(19) Europäisches Patentamt
European Patent Office
Office européen des brevets

(11) **EP 1 481 472 B1**

(12) **EUROPÄISCHE PATENTSCHRIFT**

(45) Veröffentlichungstag und Bekanntmachung des Hinweises auf die Patenterteilung:
**17.12.2008 Patentblatt 2008/51**

(21) Anmeldenummer: **03718602.0**

(22) Anmeldetag: **21.02.2003**

(51) Int Cl.:
***H03D 9/06*** *(2006.01)*

(86) Internationale Anmeldenummer:
**PCT/DE2003/000542**

(87) Internationale Veröffentlichungsnummer:
**WO 2003/073602 (04.09.2003 Gazette 2003/36)**

(54) **VERFAHREN UND VORRICHTUNG ZUR ERFASSUNG UND VERARBEITUNG ELEKTRISCHER UND OPTISCHER SIGNALE**

METHOD AND DEVICE FOR DETECTING AND PROCESSING ELECTRIC AND OPTICAL SIGNALS

PROCEDE ET DISPOSITIF PERMETTANT DE DETECTER ET DE TRAITER DES SIGNAUX ELECTRIQUES ET OPTIQUES

(84) Benannte Vertragsstaaten:
**AT BE BG CH CY CZ DE DK EE ES FI FR GB GR HU IE IT LI LU MC NL PT SE SI SK TR**

(30) Priorität: **22.02.2002 DE 10207610**

(43) Veröffentlichungstag der Anmeldung:
**01.12.2004 Patentblatt 2004/49**

(73) Patentinhaber: **Schwarte, Rudolf**
**57250 Netphen (DE)**

(72) Erfinder: **Schwarte, Rudolf**
**57250 Netphen (DE)**

(74) Vertreter: **Weber, Roland et al**
**Weber, Seiffert, Lieke**
**Patentanwälte**
**Postfach 6145**
**65051 Wiesbaden (DE)**

(56) Entgegenhaltungen:
**EP-A- 1 152 261        WO-A-99/60629**
**DE-A- 19 704 496**

• **SCHWARTE R ET AL: "New electro-optical mixing and correlating sensor: facilities and applications of the photonic mixer device (PMD)" , PROCEEDINGS OF THE SPIE, SPIE, BELLINGHAM, VA, US, VOL. 3100, PAGE(S) 245-253 XP002080273 ISSN: 0277-786X Seite 246, Zeile 41 -Seite 248, Zeile 29; Abbildung 2**

**Beschreibung**

Die vorliegende Erfindung betrifft ein Verfahren und eine Vorrichtung zur Erfassung und/oder Verarbeitung von Signalwellen, die in einem auf die Signalwellen empfindlichen Gegenstand Ladungsträger erzeugen, die in mindestens einer Ausleseelektrode einen Signalstrom hervorrufen, wobei mindestens zwei Modulationselektroden vorgesehen sind, von denen mindestens eine in räumlicher Nähe zu der mindestens einen Ausleseelektrode und die andere in räumlicher Nähe entweder zu derselben Ausleseelektrode oder zu einer weiteren Ausleseelektrode angeordnet sind.

Entsprechende Verfahren und Vorrichtungen sind beispielsweise als "PMD-Elemente" aus der deutschen Patentanmeldung Nr. 196 35 932.5 bzw. der entsprechenden internationalen Patentanmeldung WO 9810255 sowie aus der DE 198 21 974.1 und der korrespondierenden internationalen Patentanmeldung WO 9960629 bekannt.
Der Stand der Technik für diese inhärente Vorverarbeitung optischer Signalwellen wird z.B. in "Handbook of Computer Vision and Applications", Volume 1, Sensors and Imaging, edited by Jähne et al., Academic Press, auf S. 463ff, ferner in Dutzenden von Veröffentlichungen über Anwendungen als Laserradar, 3D-Kamera und OE-Schnittstelle für die Kommunikation, z.B. auf der Homepage des Instituts für Nachrichtenverarbeitung der Uni Siegen, beschrieben.
Dieser bekannte Photomischdetektor (PMD) liefert eine Gegentaktmultiplikation und -korrelation der optischen Signalwelle mit einem elektrischen Gegentaktsignal und erzielt eine hohe Rausch- und Hintergrundlichtunterdrückung und weiterhin eine wesentliche Vereinfachung und Verbesserung von Zeitmessungen. Der bekannte PMD bzw. die damit angewendeten Verfahren sind jedoch relativ unflexibel und weisen keine Zeitselektion, keinen inhärent schaltbaren Nullzustand des Ausgangssignals und keine analoge oder digitale Verknüpfung mehrerer elektrischer und optischer Eingangssignale auf. Insbesondere ist es mit diesem bekannten Verfahren und dem bekannten PMD nicht möglich, unterschiedliche optische Signale miteinander zu mischen und zu verknüpfen.

Das breite Spektrum elektromagnetischer, insbesondere optischer Technologien und Verfahren zur Gewinnung, Verarbeitung und Übertragung von Informationen besitzt zusammen mit den mikroelektronischen und mikrooptischen Technologien eine Schlüsselfunktion in der Forschung, Entwicklung und Produktion und eine wachsende Bedeutung im internationalen wirtschaftlichen Wettbewerb.
Daher spielen die unmittelbare Verarbeitung und Verknüpfung von Strahlungssignalen - insbesondere optischen Signalen - mit elektrischen Signalen, z.B. opto-elektronischen (OE) Schnittstellen-Komponenten zwischen optischen und elektrischen Technologien und Systemen, den OE-Wandlern als Empfängern und den EO-Wandlern als Sendern (z.B. Laserdioden), aber auch optischen Signalen untereinander, eine hervorragende Rolle.

Die beeindruckenden Erfolge und großen Vorteile der optischen Informationsverarbeitung könnten wesentlich besser genutzt und erweitert werden durch ein entsprechendes vielseitiges und intelligentes Verfahren zur optoelektronischen Erfassung, Verarbeitung und Übertragung mit neuen Möglichkeiten zur direkten inhärenten digitalen und analogen Signalverarbeitung der eintreffenden optischen Signalwelle mit elektrischen Signalen oder anderen optischen Signalen, das zudem mikroelektronisch und mikrooptisch integriert in Form von OE-Interface-Komponenten bzw. OE-Prozessor-Komponenten kostengünstig durchführbar ist.

Anzustreben wäre ein OE-Signalverarbeitungsverfahren und seine Durchführung als OE-Signalverarbeitungskomponente, welches gleichermaßen ohne zusätzliche Elektronik und sozusagen auf einem integrierten Sensorelement, daß auf Signalwellen empfindlich ist, die analoge und digitale wechselseitige Verarbeitung und Verknüpfung von optisch/ elektrischen, optisch/optischen und elektrisch/elektrischen Signalen und Signalwellen ermöglicht

Gegenüber dem obigen Stand der Technik liegt der vorliegenden Erfindung demnach die Aufgabe zugrunde, ein Verfahren und eine Vorrichtung zu schaffen, das in der Lage ist, verschiedene optische und/oder elektronische Signale miteinander logisch digital oder analog zu verknüpfen oder auch den Verlauf optischer Signale durch Abtasten (Kurzzeitmessungen) zu erfassen.

Diese Aufgabe wird hinsichtlich des Verfahrens durch die Merkmale des Anspruchs 1, und hinsichtlich der Vorrichtung durch die Merkmale des Anspruchs 14 gelöst.

Gemäß der vorliegenden Erfindung gelingt also die Implementierung der ersten OE-Signalverarbeitungsschritte unmittelbar in den Detektionsprozeß einer neuartigen opto-elektronischen Empfangs-und Steuerungskomponente, die zugleich die hohen Anforderungen nach mikroelektronischer Integration, hoher Bandbreite und Geschwindigkeit und niedrigen Kosten erfüllt.

Gemäß dem erfindungsgemäßen Verfahren können die Modulationselektroden mit relativ zueinander frei wählbaren Modulationsspannungen und/oder frei wählbaren Phasenbeziehungen moduliert werden, wobei die durch die Modulationsspannungen beider Modulationselektroden erzeugten Ausleseströme vorzugsweise additiv gekoppelt werden. Hinsichtlich der Vorrichtung wird die der Erfindung zugrunde liegende Aufgabe dadurch gelöst, daß die Modulationselektroden relativ zu der bzw. den Ausleseelektrode(n) derart angeordnet sind, daß in Abhängigkeit vom Vorzeichen der Modulationsspannung der jeweiligen Modulationselektroden der über die zugehörige Ausleseelektrode fließende Strom positiv oder negativ ist und daß mindestens eine Einrichtung vorgesehen ist, durch welche die relative Phasenbeziehung und/oder die Amplitude der beiden Modulationsspannungen frei einstellbar ist.

Die bekannten PMD-Elemente waren dadurch gekennzeichnet, daß die beiden Modulationselektroden genau im Gegentakt arbeiteten und dadurch die durch Strahlungseinfall erzeugten Ladungsträger abwechselnd auf je eine von mindestens zwei auf diese Elektroden bzw. Elektrodengruppen leiteten. In einer bevorzugten Variante des PMD-Prinzips wurden die Ausleseströme oder Spannungen der Ausleseelektroden voneinander subtrahiert, um dadurch die Korrelation der Modulationsfrequenz mit einer Frequenz der Signalwellen zu erfassen, die in einer wohldefinierten Beziehung zu der Modulationsfrequenz der Modulationselektroden stehen mußte.

Im Gegensatz hierzu sieht die vorliegende Erfindung in ihrer einfachsten Variante nicht zwingend eine Modulation der Signalwelle vor, wohl aber Modulationselektroden, deren Spannungsverläufe und relative Phasenbeziehung frei einstellbar sind. Da erfindungsgemäß weiterhin vorgesehen ist, daß in Abhängigkeit von dem Vorzeichen der Modulationsspannung der jeweiligen Modulationselektrode der über die zugehörige Ausleseelektrode fließende Strom entweder eindeutig positiv oder eindeutig negativ ist, ist es beispielsweise bei entgegengesetzter Phase der beiden Modulationsspannungen möglich, daß die beiden addierten Ströme der Ausleseelektroden, von denen dann notwendigerweise einer positiv und einer negativ sein muß, einander zumindest teilweise aufheben. Vorzugsweise erfolgt die räumliche Anordnung der Elektroden und die Auswahl der Modulationsspannungen in der Weise, daß bei einem Arbeiten der Modulationselektroden im Gegentakt die beiden positiven und negativen Ausleseströme einander exakt aufheben. Dieses entspricht einer sogenannten "Null-Schaltung" bzw. einem Abschalten des Sensors durch einen sogenannten "Modulationszustand Null" MZ0. Durch einen Wechsel der Phasenbeziehung wird jedoch sofort ein positiver oder negativer Strom gemessen, je nachdem, in welche Richtung der Phasenwechsel erfolgte.

Damit ist es beispielsweise möglich, konstant oder nur kurzzeitig ein z.B. auf den Sensor einfallendes Lichtsignal zu messen und gegebenenfalls durch jeweiliges kurzzeitiges Umschalten der Phase einer der Ausleseelektroden abzutasten. Die Besonderheit der erfindungsgemäßen Vorrichtung und des entsprechenden Verfahrens liegt darin, daß zwar im Prinzip eine dauerhafte, kontinuierliche Messung stattfindet und in dem Sinne kein eigentliches "Einschalten" und/oder Abschalten des gesamten Sensors erforderlich ist, sondern vielmehr nur die Meßbedingungen kurzzeitig geändert werden, daß zwei sich zuvor aufhebende Signale miteinander addiert werden oder zumindest einander nur noch teilweise aufheben.

Zu der Verwendung der in den Ansprüchen verwendeten Begriffe ist anzumerken, daß ein auf Signalwellen empfindlicher Gegenstand beispielsweise ein lichtempfindlicher Halbleiter oder ein Photowiderstand sein kann oder allgemein ein Halbleiter, der auf elektromagnetische Wellen (einschließlich des Bereiches oberhalb und unterhalb der Wellenlängen des sichtbaren Lichts), sein kann, daß ein solcher Gegenstand auch eine Photokathode sein kann, bei der die Signalwelle freie Elektronen im Vakuum erzeugt, die durch Modulationselektroden wählbar zu mindestens einer Gruppe von Ausleseelektroden hin steuerbar ist. Dieser Gegenstand kann aber auch beispielsweise eine Mikrokanalplatte sein mit einer vom MCP-PMD (Micro-Channel-Plate PMD) her bekannten PMD-Fingerstruktur [R. Schwarte, EDMO Proceedings, Wien, November 15-17], jedoch in dem erfindungsgemäßen Betrieb als Optoelektronischer Prozessor OEP mit frei wählbaren Modulationszuständen, die insgesamt nicht als lichtempfindliches Halbleitermaterial zu bezeichnen ist. Ein auf Signalwellen empfindlicher Gegenstand ist also generell jeder beliebige Gegenstand, in welchem Signalwellen Ladungsträger erzeugen. Unter "Modulation" in Bezug auf die Modulationselektroden wird im Prinzip jede veränderbare Spannung verstanden, wobei im Extremfall auch Konstantspannungen im Sinne der vorliegenden Erfindung als aperiodische "Modulationsspannungen" angesehen werden, solange nur mindestens eine der beiden Konstantspannungen zumindest kurzzeitig moduliert werden, insbesondere einen Vorzeichenwechsel ausführen kann. In einer bevorzugten Ausführungsform sind jedoch die Modulationsspannungen und insbesondere auch deren Amplituden frei variierbar. Hierdurch ist es insbesondere möglich, etwaige Asymmetrien der räumlich-körperlichen Ausgestaltung und Anordnung der Elektroden auszugleichen und dadurch sicherzustellen, daß bei eingesetzten Vorzeichen der Modulationsspannungen die addierten Ausleseströme einander genau aufheben.

Weiterhin ist es gemäß einer bevorzugten Ausführungsform der Erfindung vorgesehen, daß mehrere verschiedene Signalströme, die durch unterschiedliche bzw. voneinander getrennte Signalwellen auf getrennten Sensorelementen bzw. -vorrichtungen gemäß der vorliegenden Erfindung erzeugt werden, miteinander addiert werden. Eine besonders bevorzugte Ausführungsform des erfindungsgemäßen Verfahrens besteht darin, daß auch die Signalwellen moduliert werden, wobei die Modulationen der Modulationselektroden in einer wohldefinierten Beziehung zu der Modulation der Signalwellen stehen. Auf diese Weise kann man das oben diskutierte, bereits bekannte PMD-Prinzip mit dem Verfahren gemäß der vorliegenden Erfindung gleichzeitig anwenden und die Messung von Signalen nach dem Prinzip der vorliegenden Erfindung derart durchführen, daß ausschließlich das Signal der modulierten Signalwelle erfaßt und alle Hintergrundsignale eliminiert werden. Hierzu wird mindestens eines der Grundelemente gemäß der vorliegenden Erfindung, bestehend aus mindestens einer Ausleseelektrode und mindestens zwei Modulationselektroden, in der Weise verwendet, daß beide Modulationselektroden phasengleich einen schnellen Vorzeichenwechsel der Modulationsspannung erfahren, wobei der Auslesestrom über mindestens eine solche Periode (eines Modulationsspannungswechsels) integriert wird.

Es versteht sich, daß dabei die Signalwellen moduliert sein müssen und daß die Modulationen der Modulationselektroden in einer wohldefinierten Beziehung zu der Modulation der Signalwellen stehen.

Sofern Signale von verschiedenen Elementen miteinander verknüpft werden sollen, kann man durch entsprechende Modulation der Phasenbeziehungen der Modulationsspannungen an den verschiedenen Elementen, welche die miteinander zu verknüpfenden Signale empfangen, logische Verknüpfungen wie AND (UND), OR (ODER), XOR (AUSSCHLIEßLICH ODER) und deren Verneinungen realisieren.

Besonders bevorzugt ist eine Ausführungsform der Erfindung, bei welcher der auf Signalwellen empfindliche Gegenstand ein lichtempfindliches Halbleitermaterial ist und die Auslese- und Modulationselektroden als Schottky-Kontakte ausgebildet sind. Dabei können Auslese- und Modulationselektroden beispielsweise kammartig ineinandergreifen, es ist aber auch möglich, streifenartig angeordnete Elektroden einer Sorte gruppenweise nebeneinander anzuordnen und jeweils anderen Elektrodentyp (Modulationselektrode oder Ausleseelektrode), ebenfalls streifenartig auszubilden und neben der ersten Streifengruppe anzuordnen. Beispielsweise können zwei oder mehr benachbarte Elektrodenstreifen bzw. -kontakte eine einheitliche Ausleseelektrode bilden und daneben können mehrere Streifen, die elektrisch miteinander verbunden sind, eine Modulationselektrode bilden. Der Begriff "lichtempfindlich" ist hierbei weit auszulegen und soll keine Beschränkung auf das optische Spektrum bedeuten, solange nur bei dieser Ausführungsform ein Halbleitermaterial zur Verfügung steht, daß auf elektromagnetische Wellen empfindlich ist und in welchem durch die auftreffenden elektromagnetischen Wellen bewegliche Ladungsträger erzeugt werden.

Um das PMD-Prinzip anwenden zu können, muß eine modulierte Signalwelle vorliegen, so daß in der bevorzugten Ausführungsform entweder Einrichtungen zum Aussenden und Modulieren einer Signalwelle vorgesehen sind oder aber mindestens eine PLL-Eingangsschaltung zur Erfassung der Signalmodulation und der Anpassung der Modulationsfrequenz der Modulationselektroden und auch zur Einstellung der Phase der Modulation der Modulationselektrode vorgesehen sind.

Das erfindungsgemäße Verfahren und die entsprechende Schaltung verarbeiten im gleichen Prozeß optische Signalwellen und elektrische Signale in vielfältiger über den Stand der Technik hinausgehender Weise. Aufgrund der flexiblen und vielfältigen Funktionen und Prozessierungsmöglichkeiten für optische und elektrische Signale wird im folgenden das erfindungsgemäße Verfahren als Optoelektronisches Prozessor-Prinzip, kurz OEP-Prinzip und die entsprechende Vorrichtung als Optoelektronischer Prozessor, kurz OEP, bezeichnet. Das OEP-Prinzip ermöglicht insbesondere Folgendes:

1) Zwei unabhängige elektrische Signale werden mit einem optischen Signal P(t) inhärent so verknüpft, daß der zugehörige ausgangsseitige Photostrom bei konstanter Bestrahlung elektrisch steuerbar ist im gesamten Bereich vom größten Negativwert Modulationszustand MZN über den Nullzustand MZ0 bis zum größten Positivwert Modulationszustand MZP, womit die Grundfunktion des sog. Einfach-OEP bezeichnet wird.

2) In Erweiterung der Funktionalität werden zwei unabhängige elektrische Signale mit zwei optischen Signalen $P_1$(t) und $P_2$(t) inhärent so verknüpft, daß der ausgangsseitige Photostrom dieses sog. Zweifach-OEP zusätzlich auch von den beiden optischen Signalen in den Grenzen der verfügbaren Photoströme analog und digital steuerbar zwischen den möglichen Grenzzuständen MZN und MZP ist. Wenn beim Zweifach-OEP bei gleich wirksamen Leistungen $OEP_1$ mit $P_1$ den Strom $I_{A1}$ bewirkt und $OEP_2$ mit $P_2$ den Strom $I_{A2} = I_{A1}$ bewirkt, dann ergibt die Kombination z.B. für die Differenzstromauslese : Für ($P_1$, $P_2$) = MZ0 wegen $I_{A1} - I_{A2} = 0$ bzw. logisch "0"; für ($P_1$, 0) = MZP wegen $I_A = I_{A1}$ entsprechend logisch "1" und für (0, $P_2$) = MZN wegen $I_A = -I_{A2}$ entsprechend logisch "0" in der Binärlogik bzw. logisch "-1" in der Ternärlogik.

3) Durch weitere Integration und Zusammenschaltung derartiger OEP-Komponenten in unterschiedlichen Technologien entstehen viele neuartige komplexe OE-Signalverarbeitungs- und Messverfahren und -systeme für ein breites Spektrum aktueller Aufgabenstellungen aus der Industrie, Wissenschaft und Gesellschaft.

Anwendbar ist der erfindungsgemäße Optoelektronische Prozessor OEP für die Erweiterung der OE-Signalverarbeitungsfunktionalität, z.B. zur elektrischen Ein- und Abschaltung des Detektors, wie für Zeitmultiplexanwendungen unerläßlich, ferner für eine Erhöhung der Bandbreite eines schaltbaren EO-Mischers von DC bis in den GHz-Bereich, für die Verbesserung und Vereinfachung der Hintergrundlicht-Unterdrückung, die Realisierung schneller optisch-elektrischer und optisch-optischer Gatterfunktionen mit der entsprechenden Basisbandfähigkeit, sowie die Integration räumlich verteilter Verarbeitungsfunktionen, z.B. Parallelkommunikation und dynamische 3D-Messungen in der Raum-Zeit und im Ortsfrequenzbereich für laterale Geschwindigkeitsmessungen. Die neue gesuchte OE-Komponente bietet Anwendungen im Kommunikationsbereich, z.B. für die CDMA/TDMA-Freiraumübertragung, in der optischen Vernetzung einer sog. Optical Backplane anstelle der Multi Layer Backplane sowie in Polymer-Fasernetzwerken mit einer Bitrate von z.B.1 Gb/s bei gleichzeitig hoher Empfindlichkeit und hohem Füllgrad. Diese Spezifikationen werden heute von keinem bekannten, auch nur annähernd preisgünstigen Bauelement erfüllt.

Gemäß der vorliegenden Erfindung können z.B. schnelle OE-Gatter, OE-Analogschalter, OE-Sampler, OE-Analog-Digital-Umsetzer, OE-Multiplexer und -Demultiplexer, 3D-Kameras auf OEP-Array-Basis kombiniert nach dem Laufzeitprinzip, Triangulationsprinzip und der Doppler verschobenen Ortsfrequenzanalyse, für vielkanalige und kostengünstige OE-Router (Optical Cross-Connect), hochempfindliche und schnelle Mischer und Korrelatoren realisiert werden. Weiterhin können die Anwendungsbereiche und das Spektrum der Signalwellen z.B. durch neue Materialien und Technologien erweitert und zur Durchführung solcher Verfahren entsprechende Vorrichtungen realisiert werden.

Der Erfindung liegt die Erkenntnis zu Grunde, daß - über den bekannten Ladungsschaukelprozess des PMD-Prinzips wesentlich hinausgehend - beim OEP-Prinzip durch analoge und/oder digitale signalverarbeitende Kombination und Verknüpfung von mindestens einer oder mehreren funktionell kooperierenden Signalwellen P(t), die in mindestens einem photosensitiven Bereich Photoladungen generieren, mindestens zwei unabhängige Modulationssignale UM über Modulationselektroden M den Fluß der zugehörigen Photoladungen zu räumlich eng benachbarten Ausleseelektroden A vzw. auf Massepotential steuern und die Ausleseströme additiv oder subtraktiv zu mindestens einem Ausgangswert, Stromwert IA oder Spannungswert ∆UA, in bzw. über eine Ausleseeinheit VAEH zusammengefaßt werden.
Vorteilhaft sind hoch integrierbare OEP-Strukturen, die vzw. von PMD-Strukturen wie MSM(Metal Semiconductor Metal)-PMD sowie (p$^+$n$^-$p$^+$)- oder (n$^+$p$^-$n$^+$)-PMD ausgehen - letztere wegen der vorteilhaften Fremdmodulations-Unterstützung durch vzw. isolierte und mit einer geeigneten OffsetSpannung beaufschlagten Metallelektroden auch ME-PMD genannt [R. Schwarte, EDMO Proceedings, Wien, November 15-17, PCT DE 00/03632, PCT DE 01/03914] - und erfindungsgemäß sehr einfache und effektive Schaltungsstrukturen hoher Funktionalität erlauben.

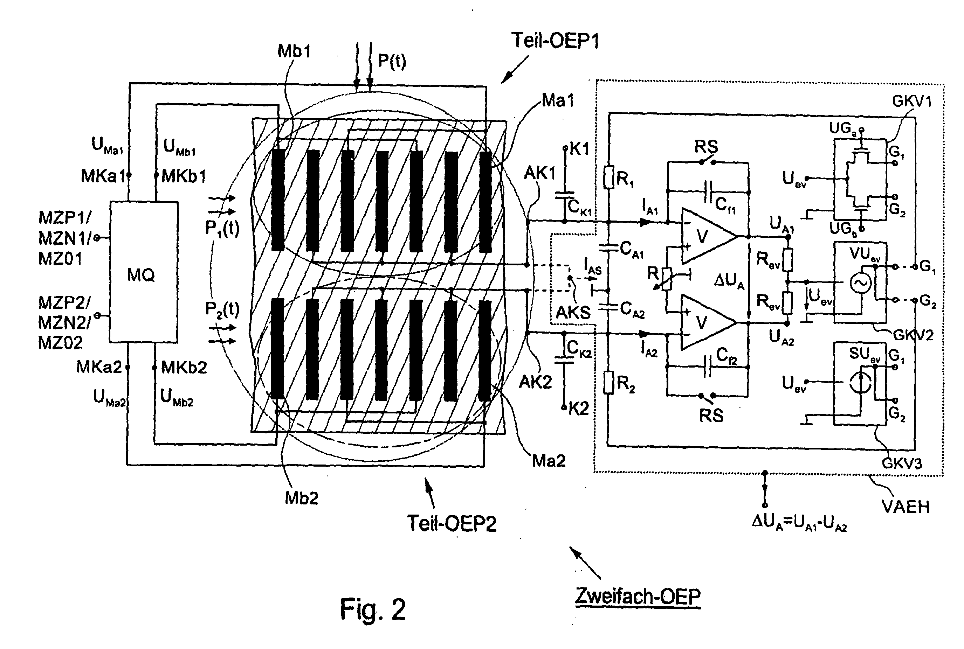

Das erfindungsgemäße OEP-Prinzip ist ebenfalls auf Basis der bekannten PMD-Strukturen durchführbar, insbesondere auf Basis der PG(Photo Gate)-PMD-Technologie [DE196 35 932.5, DE 198 21 974.1] und der MCP (Micro Channel Plate)-PMD-Technologie [PCT DE 00/03632, PCT DE 01/03914]. Dazu werden mindestens zwei Gruppen von PG-PMD-Streifenstrukturpixel OEP$_1$ und OEP$_2$ - vzw. verschachtelt -jeweils über die unabhängigen Gegentaktmodulations-Spannungen ±UM für die Photo-Gate-Paare gesteuert und alle zugehörigen Ausleseelektroden-Paare A$_l$ für links und A$_r$ für rechts der Ladungsschaukel verbunden und mit den Ausleseströmen I$_{Ar}$ = I$_{Ar1}$ + I$_{Ar2}$ sowie I$_{Al}$ = I$_{Al1}$ + I$_{Al2}$ zu einem Gegentaktausgang mit dem unipolaren Gegentaktstrom +IA = IAr - IAl bzw. zu der entsprechenden Ausgangsspannung ∆U$_A$ zusammengefaßt. Diese Durchführung des PG-OEP-Prinzips in CMOS-Technologie weist einige Vorteile der gut beherrschten Technologie und Integrierbarkeit auf, denen aber Nachteile des PG-OEP's in der Schaltgeschwindigkeit entgegen stehen . Zur notwendigen Kompensation des Photostroms der Hintergrundbeleuchtung beim PG - OEP dienen die erfindungsgemäß vorgeschlagenen Konzepte der Differenzauslese mit reiner Verstärkerfunktion oder mit Integratorfunktion gemäß Fig. 2,mit einer Gleichtaktgegenkopplung des vom PG - PMD her bekannten unvermeidlichen Gegentaktstromanteils.
Vorzugsweise werden zusätzliche isolierte und modulierte Metallelektroden ME geeigneter Breite über den Ausleseelektroden A und/oder über den Modulationselektroden M vzw. bei den OEP-Strukturen auf Halbleiterbasis verwendet, die in mehrfacher Hinsicht vorteilhaft sind: 1) Die in den Randbereichen der Elektroden wirksame Abschirmung von Signalwellen verhindert dort eine Ladungsträger-Paarbildung, die bei hohen Frequenzen wegen der weiteren Wege nicht hinreichend genutzt wird und den Modulationskontrast verringert. 2) Die abschirmenden Metallelektroden ME der Modulationselektroden werden über eine geeignete kapazitive Kopplung zur Unterstützung des Modulationsdurchgriffs mit vzw. etwa der gleichen oder einer erhöhten Amplitude des Modulationssignals UM und vzw. auf dem gleichen oder einem verschobenen DC-Potential betrieben. 3) Liegt jeweils eine Ausleseelektroden A zwischen zwei gleichsinnig modulierten Modulationselektroden M, so wird ihre abschirmende Metallelektrode ME vzw. über eine geeignete kapazitive Kopplung zur Unterstützung des Modulationsdurchgriffs mit vzw. etwa der gleichen oder einer kleineren Amplitude des Modulationssignals UM aber entgegen gesetzter Polarität moduliert und vzw. auf dem gleichen oder einem verschobenen DC-Potential betrieben.

Das erfindungsgemäße OEP-Verfahren und die Vorrichtungen zu seiner Durchführung erlauben u.a. einen Multi-Pixel-Samplingbetrieb vzw. optischer Signalwellen, bei dem sich alle OEP-Pixel zunächst im Modulations-Zustand Null MZ0 befinden. Die beiden durch UMa und UMb steuerbaren Ausgangsströme je OEP-Pixel ergeben durch gegenseitige Kompensation - gleich ob über ±Stromsummation gemäß Wired-Or-Auslese oder durch (++) oder (- -)-Differenzstromauslese am Ausgang der Ausleseeinheit jeweils den Ausgangswert Null (Modulationszustand MZ0). Eine Abtastung eines 3D-Bildpunktes der räumlichen Signalwelle erfolgt durch kurzzeitiges Verlassen des Kompensationszustandes MZ0 in Richtung einer positiv oder negativ wählbaren Abtastprobe über MZP bzw. MZN. Dieser nach dem OEP-Prinzip ermöglichte Tastbetrieb bietet viele Vorteile, z.B. für die 3D-Erfassung von räumlichen Szenen insbesondere bei Pulsradarverfahren, die bei der 3D-PMD-Kamera nicht sinnvoll realisierbar sind. Der einfach realisierbare inhärent mögliche OEP-Abtastbetrieb ermöglicht eine 3D-OEP-Kamera mit sehr kurzen Meßzeiten bei hohen pulsförmigen Spitzenleistungen und relativ großen Meßpausen. Gleichzeitig bleiben alle bekannten Vorteile der PMD-Technik des "Correlated Balanced Sampling" und des "Non Correlated Suppression" erhalten, wenn das weiter unten erläuterte sog. Differentielle Sampling verwendet wird.
Beim MSM-OEP und vergleichbaren OEP-Strukturen geschieht die Unterdrückung eines optischen Gleichanteils, z.B. des Sonnenlichts, dadurch, daß der zugehörige Auslesestrom bei gleicher Dauer der positiven Modulations- bzw. Abtastzustände MZP und der negativen Modulations- bzw. Abtastzustände MZN, zu gleichen Anteilen hin und zurück fließt, solange das Modulationssignal keinen Gleichanteil aufweist. Diese Hintergrundlicht-Unterdrückung erfolgt ohne einen zusätzlichen schaltungstechnischen Aufwand.

Beim erfindungsgemäßen OEP-Prinzip trifft von mindestens einer Signalquelle PQ mindestens eine Signalwelle auf den insbesondere für Photonen und Elektronen empfindlichen Gegenstand vorzugsweise auf eine regelmäßige Streifenstruktur von Schottky- oder PN-Übergängen auf einem für die Signalwelle sensitiven Bereich eines niedrig dotierten p- oder n-Substrates 3 und generiert Ladungsträger.

Beim OEP-Verfahren auf Basis der MSM-Technologie bilden vorzugsweise. streifenförmige Schottky-Dioden in der einfachsten Konfiguration eine Fingerstruktur aus 2 Gruppen von Modulationselektroden Ma und Mb sowie mindestens einer Gruppe von Ausleseelektroden A. Für eine hohe Bandbreite bzw. Schaltgeschwindigkeit sind die Streifenbreiten z.B. nur ca. 1$\mu$m breit und die photosensitiven Streifen dazwischen nur etwa doppelt so breit.

Die MSM-OEP- Struktur und die entsprechende pn-Struktur ähnlich dem ME -PMD werden vzw. auf potentialfreiem n⁻ - oder p⁻-Substrat bzw. potentialfreier n⁻ - oder p⁻-Epitaxieschicht oder in Silikon ON Insulator (SOI) ausgeführt.

Zur Verringerung des Dunkelstroms der Schottky-Übergänge wird die Ausleseelektrode n vorteilhaft in Form möglichst schmaler Doppelstreifen ausgeführt.

Bei der pn-Ausführung wird für das p⁻/n⁻-Substrat vzw. eine Sperrspannung zwischen die n⁺ bzw. p⁺ Elektrodenstreifen und der gegenüberliegenden Anode bzw. Kathode gelegt. Vorteilhaft ist auch die Anwendung von pn-Dioden in einer pip-OEP oder nin-OEP-Struktur anstelle von Schottky-Dioden in der MSM-OEP-Struktur. Dazu sollte der photosensitive n⁻ oder p⁻ -Bereich der Fingerstruktur eine Floating-Wanne mit geringen Restströmen bilden. Zusätzlich werden die p⁺ bzw. n⁺ - Elektrodenstreifen vzw. isoliert mit einer Metallelektrode abgedeckt, einerseits um eine nicht nutzbare Ladungsgeneration im Randbereich zu vermeiden und um die Modulation durch ein starkes Driftfeld zu unterstützen. Dazu wird die Breite der Metallelektrode, eine Offsetspannung zwischen Ausleseelektrode A und Metallelektrode für einen effektiven Ladungstransport und eine vzw. kapazitive Kopplung zum Modulationssignal optimiert.

In einer weiteren Ausgestaltung der Erfindung kann die Empfindlichkeit des OEP durch Avalanche-Halbleiterstrukturen im OEP und durch Sekundärelektronenvervielfachung erhöht werden.

Letzteres kann z.B. durch Vorschalten einer Photokathode und einer Mikrokanalplatte und vzw. anschließender direkter OEP-Auslese im Vakuum mittels Anodenmatrix oder mit einem CCD- oder CMOS-Pixelarray erfolgen. Erfindungsgemäß wird hierbei eine weitere Verstärkung genutzt, - auch ohne Vorschalten der Mikrokanalplatte - die in der hohen Ionisationswirkung bzw. Quanteneffizienz beschleunigter energiereicher Photoelektronen besteht und die ein Vielfaches des üblichen Photostroms betragen kann, z.B. bis zu Faktor 1000.

Die Basisfolge der Elektroden Ma - A - Mb - A ist die höchste Form der Verschachtelung und vorteilhaft, wenn der für Signalwellen empfindliche Gegenstand z.B. aus einem Halbleitermaterial ohne pn-Übergänge, z.B. aus Photowiderstandsmaterial, besteht. Vorteilhaft kann auch eine geringere Verschachtelung sein, z.B. mit der Elektrodenfolge Ma-A-Ma-A-Ma-A-Mb-A-Mb-A-Mb - A usw. Je nach den Datierungen einer pn-OEP-Struktur ist es vorteilhaft, die Ausleseelektroden zwischen Ma und Mb anders, z.B. zur Potentialeinstellung zu verwenden. Je nach gewünschter OEP-Form wird die Folge um ein Vielfaches fortgesetzt und in der Streifenlänge angepaßt. Die Verschachtelung der UMa- und UMb-Steuerungsbereiche kann sich auch auf die orthogonale Dimension erstrecken, sollte jedoch die für den Nullzustand gewünschte 50%/50%-Signalwellenverteilung von P(t) erfüllen oder könnte z.B. durch Kalibrierung über die Modulationsspannungsamplituden justiert werden. Mindestens zwei Modulationssignale UMa und UMb modulieren den Transport der Ladungsträgerpaare und bestimmen so den Auslesesummenstrom IAS der Ausleseelektroden A, der über die Ausleseklemme AK an die Ausleseeinheit VAEH und an ein Signal- und Datenverarbeitungssystem SDV zur weiteren Verarbeitung und Auswertung weiter geleitet wird.

Mit dieser einfachsten Form der OEP-Struktur ist es erfindungsgemäß möglich, den Auslesestrom stationär oder dynamisch schnell über den gesamten Aussteuerbereich des Photostroms IA von $IA_{min}$ bis $IA_{max}$ = $-IA_{min}$ zu steuern, indem die beiden Modulationsspannungen UMa und UMb entsprechende OEP-bezogene Spannungszustände annehmen.

Insbesondere erlaubt das OEP den Auslesestrom extrem schnell von $I_{max}$ auf 0 oder $I_{min}$ umzuschalten. Das beliebige Schalten dieser drei Modulationszustände stellt eine Schlüsselfunktion für viele Anwendungen und neuartige Problemlösungen dar. Im Fall einfacher Stromsummation bzw. Wired-Or-Stromauslese gilt im positiven Modulationszustand MZP gilt mit S als photosensitiver Empfindlichkeit idealisiert IA = +SxP für MZP (UMaP, UMbP) wobei UMaP und UMbP die zugehörigen optimierten positiven Modulationsspannungen darstellen. Entsprechendes gilt für den Modulationszustand MZN mit IA = -SxP für MZN (UMaN, UMbN) und für den Modulationszustand MZ0 mit IA = 0 für MZ0 (UMa0, UMb0) oder näherungsweise (UMaP, UMbN) oder (UMaN, UMbP).

Eine erweiterte Funktionalität und Flexibilität wird mit dem Zweifach- bzw. Twin-OEP erzielt. Dazu bilden zwei Einfach-OEPs eine z.B. runde oder rechteckförmige Empfangsfläche, die in mindestens zwei gleiche Teile OEP1 und OEP2 aufgeteilt ist und wobei die Leistung einer Signalwelle P(t) auf die beiden OEPs gleich verteilt ist oder jedes OEP eine eigene Signalwelle, $P_1(t)$ und $P_2(t)$, empfängt. Das Zweifach-OEP kann für eine auf OEP1 und OEP2 gleich verteilte Signalwelle P(t) vorteilhaft auch zugleich als Einfach-OEP verwendet werden. Die beiden zugehörigen Ausleseströme IA1 und IA2 werden vzw. direkt zusammengeführt und am Wired-OR-Ausgang AKS als Ausgangssummenstrom IAS ausgelesen. Zur Erzielung der drei markanten Modulationszustände werden wiederum entsprechende, einmalig abgestimmte Spannungszustände der vier Modulationsspannungen UMa1, UMb1, UMa2, UMb2 ermittelt und jeweils von der Modulationsquelle MQ geschaltet. Im Modulationszustand MZP gilt mit S als Sensitivität und einer idealisierten Quanteneffizienz von 100% für die Auslesestromsumme IAS = IA1 + IA2 = +S x P1 + S x P2 mit MZP (UMa1P, UMb1P, UMa2P, UMb2P) und entsprechend für den Modulationszustand MZN IAS = IA1 + IA2 = -SxP1 - SxP2 mit MZN (UMa1N, UMb1N, UMa2N, UMb2N) und entsprechend für den Modulationszustand MZ0 IAS = IA1 + IA2 = -SxP1 + SxP2 oder +SxP1 - SxP2 = 0 mit MZ0 (UMa1P,UMb1N, UMa2P,UMb2N). Vorteilhaft ist auch die Nutzung der Nullzustände MZ0 (MZa1P, MZb1P, MZa2N, MZb2N) und MZ0 (MZa1N, MZb1N, MZa2P, MZb2P)

Unsymmetrien im Aufbau der Fingerstruktur können durch entsprechende Messungen ermittelt und durch Abgleich oder im Rückkopplungsprozeß z.B. durch Korrektur der Modulationszustände eliminiert werden.

Besondere Vorteile bietet eine Ausgestaltung als Vierfach-OEP vzw. eine 4-Quadranten-Form oder eine Viersektoren-Kreisform, die in vielfacher Weise betrieben werden kann. Bei der Entfernungsmessung z.B. werden mehrere flexibel anpaßbare Betriebsweisen ermöglicht. Eine Signalwelle ist gleichmäßig auf OEP1 bis OEP4 verteilt. Somit können z.B. neben den vier Einzelentfernungen der Normalenvektor und der Mittenabstand dieses Oberflächenelements bestimmt werden. Gleichzeitig wird eine gewisse Sicherheit gegen Fehlmessungen erzielt.

In einer weiteren Ausgestaltung der Erfindung kann das OEP-Prinzip zum Abtasten von repetierend auftretenden Signalwellen verwendet werden.

Beim OEP-Samplingoszilloskop wird analog zum bekannten elektrischen Samplingoszilloskop vorzugsweise vielkanalig eine vorzugsweise repetierende räumlichen Signalwelle vzw. zeitlich synchron und räumlich parallel durch eine OEP-Matrix Probe für Probe abgetastet und in einem nachgeschalteten Signal- und Datenverarbeitungssystem SDV über Raum und Zeit rekonstruiert.

Der Abtastvorgang geschieht durch kurzzeitiges Umschalten des Einfach-OEP oder des Zweifach-OEP vom Ruhezustand MZ0 in den Abtastzustand MZP mit einer positiv gewichteten Probe oder in den Abtastzustand MZN mit einer negativ gewichteten Probe bei hinreichend gleich verteilter Leistung des Signalwellenbildpunktes auf die Teil-OEPs. Die Einprägung des Abtastimpulses mittels eines Modulationsspannungspaares geschieht vzw. über CR-Hochpaßglieder.

Durch Kombination positiver und negativer Proben und deren Vorzeichen richtige Gewichtung können Offset-Fehler und Rauschen wesentlich kompensiert werden.

In einer Ausgestaltung des OEP-Samplingverfahrens werden zusätzlich zur Abtastung von Amplitudenproben wahlweise auch Differenzamplitudenproben abgetastet. Dazu wird nach MZ0 kurzzeitig durch den Modulationszustand MZP zunächst eine erste negative Probe $Q_{1-}$ und unmittelbar darauf eine zweite positive Probe $Q_{2+}$ gleicher Abtastdauer im Modulationszustand MZN dem Signalwellenstrom IA entnommen.

Da im nachfolgenden Modulationszustand MZ0 die beiden Proben überlagert werden, entspricht die Differenz der beiden Ladungen $Q_{1-} + Q_{2+} = \Delta Q$ der positiven Steigungsabtastung des Signalverlaufs und stellt ein neuartiges Differential-Samplingverfahren mittels OEP dar. Eine Vertauschung der Reihenfolge $Q_{1+} + Q_{2-} = -\Delta Q$ ergibt eine negative Stei-gungsabtastung, die vorteilhaft mit der positiven kombiniert werden kann, um Fehlereinflüsse, z.B. Symmetriefehler, zu vermeiden.

Mit einem OEP-Samplingoszilloskop dieser Art können mit einer OEP-Zeile oder OEP-Matrix dynamische räumliche Signalwellen nach dem OEP-Prinzip räumlich und zeitlich abgetastet und vermessen werden, wobei die Schottky-OEP-Technologie und eine SiGe-OEP-Technologie Bandbreiten von weit über 10GHz erwarten läßt.

Dieses Multi-OEP-Abtastverfahren ermöglicht ebenfalls die Aufnahme räumlicher Bilder und schneller räumlicher Bewegungen nach dem Radarprinzip für repetierende Pulsbestrahlung in Form einer 3D-OEP-Kamera oder eines OEP-Stroboskopes.

In ähnlicher Weise kann analog zum bekannten Digital-Speicher-Oszilloskop (DSO) ein entsprechendes Multi-OEP-DSO auf Basis des OEP-Prinzips zur Vermessung einmaliger Signalwellen realisiert werden, wobei die dort eingesetzte elektrische Abtast-Halte-Schaltung durch mindestens eine OEP-Abtast-Halte-Schaltung ersetzt wird. Durch den Einsatz einer OEP-Zeile oder OEP-Matrix aus Einfach- oder Zweifach- oder Vierfach OEPs können Signalwellen räumlich und zeitlich vermessen und über die nachgeschalteten Analog-Digital-Wandler digital gespeichert werden. Dabei wird durch Unterteilung eines OEP-Pixels in z.B. 4 oder 9 oder 16 Teil-OEP-Pixel für den gleichen Signalwellenbildpunk, dieses OEP-Pixel zyklisch nacheinander als 1:4, 1:9, oder 1:16 Demultiplexer betrieben und die hohe Wandlerrate um diese Faktoren reduziert und damit eine Analog-Digital-Wandlung erst ermöglicht oder die Kosten einer extrem schnellen AD-Wandlung wesentlich gesenkt.

Vorteilhaft aufgrund der hohen Schaltgeschwindigkeit insbesondere des MSM-OEP's ist hierbei auch eine inhärent differentielle Abtastung. Dabei werden der Signalwelle nach dem OEP-Abtastprinzip anstelle jeweils nur einer Abtastprobe unmittelbar nacheinander zwei Proben mit entgegen gesetzten Vorzeichen entnommen und überlagert und gespeichert, vzw. auf einer Kapazität gegen Masse oder im Rückkopplungszweig eines Millerintegrators. Danach wird der so entstehende Differenzwert kurzzeitig für die Weitergabe an die nach geschaltete Signalverarbeitung, z.B. an einen Analog-Digital-Wandler, gehalten und danach mit einem Resetsignal auf Null gesetzt. Dieser Prozeß der entsprechenden Differentiellen OEP-Abtast-Halte-Schaltung setzt sich in schneller Folge fort, wobei durch 4/9/16-fache Unterteilung des OEP-Pixels ein entsprechendes Demultiplexen des gleich verteilten Signalwellenbildpunktes die Abtastrate weiter erhöhen kann.

Auf diese Weise kann eine schnell modulierte Signalwelle als optisches Zeitmultiplexsignal durch die sequentielle Abtastung der gleich verteilten Signalwelle durch eine OEP-Matrix bzw. ein OEP-Pixelarray z.B. auf Basis des OEP-Parallel-Samplers als OEP-Demultiplexer DEMUX eingesetzt werden, der das Multiplexsignal in langsamere parallele elektronische oder optische Kanäle verteilt.

Eine OEP-Matrix kann erfindungsgemäß auch als OEP-Multiplexer MUX eingesetzt werden. Dazu werden mehrere parallele optische Signalwellen über eine OEP-Matrix in zeitlicher räumlicher Folge zyklisch abgetastet und seriell als Strom- oder Spannungswerte oder über eine direkte EO-Umwandlung mittels LED oder Laserdiode als optische Werte im Zeitmultiplex weitergegeben. Erfindungsgemäße OEP-Pixelarrays können als OEP-Multiplexer MUX optisch parallele Kanäle von Raummultiplexsignalen in schnellere Zeitmultiplexsignale kleinerer Kanalzahl umsetzen.

Eine Kombination eines OEP-Demultiplexers mit vielen sich im Code-, Zeit-, Phasen- und Raummultiplex überlagernden optischen Eingangskanälen mit einer erfindungsgemäßen OEP-Matrix als code-, zeit-, phasen- und raumselektivem OEP-Empfänger und eines OEP-Multiplexers kann vorteilhaft für ein OE-Routing ein OEP-Router mit derartig kombinierter räumlicher TDMA- und CDMA-Technik eingesetzt werden. Dazu wird im Zeitmultiplex- oder im Codemultiplex-Betrieb oder im gemischten Zeit- und Codemultiplexbetrieb von einem Array von Signalquellen SQ z.B.. einem Array von ankommenden Signalwellen P(t), die eine Matrix von Einfach- oder Zweifach-OEPs z.B. über eine refraktive oder diffraktive Optik möglichst gleich verteilt bestrahlen, von der Router- bzw. Cross-Connect-Steuerung vzw. selektiv und wahlfrei auf Grund übereinstimmender Sende- und Empfangszeiten und/oder übereinstimmender Codierung und Phase durchgeschaltet.

Das selektive wahlfreie OE-Durchschalten bzw. Vermitteln vieler paralleler Eingangskanäle, z.B. eines Arrays von optischen Fasereingängen oder eines LED- oder VCSEL-Arrays auf ein OEP-Array mit zunächst elektronischen und nachfolgend wahlweise optischen Ausgangskanälen, kann mittels einer Freiraumausbreitung über größere Abstände und über Reflexionen der jeweiligen Raumbegrenzung z.B. in einem Büroraum, einem Fahrzeugraum, einem Gehäuseraum oder in einer vzw. optisch transparenten bzw. semitransparenten Trägerplatte (Optical Backplane) erfolgen. Dabei kann zwischen allen möglichen Kanälen von einem Signalquellenarray zu allen Kanälen eines OEP-Empfangsarrays eine wahlfreie Selektion und Durchschaltung z.B. im Codemultiplex und / oder im Zeitmultiplex und/oder im Frequenzmultiplex erfolgen.

Eine weitere Ausgestaltung der Erfindung betrifft die Verknüpfung der elektrischen und optischen Signale durch logische Gatter- und Speicherfunktionen, die in ihrer Vielfalt nur beispielhaft beschrieben werden können. Werden z.B. zwei Signalwellen P1 und P2 auf ein Zweifach-OEP - erweiterbar auf ein Vielfaches von Signalwellen und Zweifach-OEPs - mit jeweils einer Wired-OR-Verknüpfung WOR der Ausleseströme und einer Stromauslese durch einen Strom-Spannungsverstärker $V_R = Uout/IAS$ mit dem Ausgang $U_{out}$, einem nachgeschalteten Absolutglied ABS, vzw. ein schneller von $U_{out}$ komplementär angesteuerter Emitter- oder Source-Folger-Paar mit verbundenem gemeinsamen Ausgang IU$_{out}$I und einem nachgeschalteten elektrooptischen Wandler zur Umsetzung von IU$_{out}$I in P$_{out}$, vzw. eine LED oder Laserdiode, die vzw. direkt z.B. auf einer GaAS- oder GalnASP-OEP-Struktur integriert sein kann, gegeben, so entstehen folgende Möglichkeiten zur Signalverknüpfung: Durch Umschalten der drei Modulationszustände können die logischen Eigenschaften flexibel verändert werden. Für die Modulationszustände MZP für P1 und MZN für P2 oder umgekehrt ergibt sich folgende logische Funktionstabelle, bei der vorteilhaft auch temäre Zustände genutzt werden können, die hier aber nur bezüglich einer binären Logik betrachtet werden sollen und für den Ausgang IUoutI und Pout eine direkte optische OEP-XOR-Verknüpfung von P1 und P2 erzeugen:

**Tabelle 1**

| OEP-XOR-Gatter | P1 | P2 | Uout | IUoutI / Pout |
|---|---|---|---|---|
| Für MZP/MZN bzw. für MZN/ MZP | 0 | 0 | 0 | 0 |
| | 1 | 0 | 1 | 1 |
| | 0 | 1 | -1 | 1 |
| | 1 | 1 | 0 | 0 |

Diese OEP-Logikstruktur kann relativ einfach, flexibel und extrem schnell in ihrer Funktion umgeschaltet werden, z.B. durch die Modulationszustände MZP für P1 und P2 in ein OEP-OR-Gatterfunktion entsprechend der folgenden Wahrheitstabelle, wobei hier die binäre Logik betrachtet wird und die erfindungsgemäßen Möglichkeiten zur Nutzung der ternären Zustände nicht weiter veranschaulicht werden:

**Tabelle 2**

| OEP-OR-Gatter | P1 | P2 | Uout | IUoutI / Pout |
|---|---|---|---|---|
| Für MZP/MZP | 0 | 0 | 0 | 0 |
| | 1 | 0 | 1 | 1 |
| | 0 | 1 | 1 | 1 |
| | 1 | 1 | 2 (^1) | 2 (^1) |

Für die Modulationszustände MZN/MZN für die beiden Modulationsspannungspaare der Teil-OEPs ergibt sich auf Grund der Negation aus der OR-Folge [0,1,1,1] eine entsprechende NOR-Folge [1,0,0,0] bzw. für $\overline{P1}$ und $\overline{P2}$ eine NAND-Verknüpfung.

Die jeweils letzten Positionen der beiden Tabellen 1 und 2 unten rechts bieten die Möglichkeit einer rein optischen schnellen Auslese elektrischer Logikzustände z.B. aus einem Datenspeicher. Der abzurufende Zustand z.B. "Low" = negative und "High" = positive Spannung wird an die Modulationselektroden M2a/b gelegt und kann aus der optischen Rückmeldung Pout = Low oder High entsprechend UM2a/b = positiv oder negativ abgelesen werden, wenn P1 und P2 beide "High", daß heißt, wenn beide eingeschaltet sind und UM1a/b konstant positiv ist.

In ähnlicher Weise können mit dieser beschriebenen Logikstruktur - vereinfacht und ohne Datensicherheitsmaßnahmen betrachtet - Daten extrem schnell optisch in einen Speicher eingegeben und über Uout - ggf. unter Taktableitung aus dem P1-Valid-Signal - z.B. in ein Flipflop eingeschrieben werden, da z.B. mit P1 = High und "Valid", mit UM1a/b=positiv und mit UM2a/b=negativ der P2-Zustand Low/High unmittelbar an den Ausgang Uout weiter gegeben wird.

Aus der Vielzahl der Anwendungsmöglichkeiten der aufgeführten Logikanwendungen kommt dem XOR-Gatter im Zusammenhang mit Phasenregelkreisen, insbesondere dem Delay-Locked-Loop DLL eine besondere Bedeutung zu.

Das erfindungsgemäße OEP-XOR-Gatter eröffnet völlig neue Möglichkeiten in optischen Systemen z.B. als extrem schneller digitaler inkohärenter Opto-Opto-Mischer für Inkohärent-Optisch-Optische PLL und DLL insbesondere in digitalen Phasenregelkreisen.

OEP-Logikstrukturen eignen sich besonders für den OE-Schnittstellenbereich. Weitere Verarbeitungsschritte z.B. mit Flipflopstrukturen sind z.Zt. in konventioneller Art weit kostengünstiger.

Jedoch besteht erfindungsgemäß die Möglichkeit, durch geeignete Erweiterung dieser OEP-OR-Gatterschaltung mit einfacher oder wechselseitiger elektrischer und/oder optischer Rückkopplung schnelle, optische OEP-Flipflop-Schaltungen OEP-FF in den verschiedenen bekannten Variationen ohmscher und/oder kapazitiver Rückkopplung als bistabiles (D-FF, JK-FF), monostabiles, astabiles Flipflop, und als Schmitt-Trigger zu realisieren. Anwendungsbeispiele im Low Cost-Bereich sind OE-Sensorik, Optischer Sender bzw. Anzeige und OE-Schnittstellen insbesondere druckbare, optisch beschreibbare und optisch auslesbare Etiketten auf Polymerelektronik-Basis und OLED-Basis.

Erfindungsgemäß erlaubt das OEP neben den schnellen Schaltmöglichkeiten, neben den logischen Funktionen und wechselseitigen, teilweise rückgekoppelten Verknüpfungsmöglichkeiten eine extrem schnelle Mischung und Korrelation von Signalwellen, vzw. optischer Signale, mit elektrischen Signalen.

Bei digitalen Modulationssignalen bedeutet diese Mischung bzw. Korrelation, daß das Modulationsspannungspaar im Gegentakt zwischen den Modulationszuständen MZP und MZN geschaltet wird.

Einfach-OEPs bzw. Zweifach-OEPs werden erfindungsgemäß als Mischer und Korrelator von mindestens einem Modulationsspannungspaar an mindestens einer Modulationselektrodengruppe und mindestens einer vzw. modulierten Signalwelle $P = P_0 + p(t)$ mit einem Gleichanteil $P_0$ und einem Wechselanteil $p(t)$ betrieben.

Dabei wird im Idealfall der Auslesestrom jeweils mit $IA = IAo + i_A(t)$ bzw. $IAS = IA1 + IA2 = IAS_0 + i_{AS}(t)$ zu 100% und symmetrisch durch die Modulationsspannungen $UMa = UMao + u_{ma}(t)$ und $UMb = UMbo + u_{mb}(t)$ mit vzw. $u_{ma}(t) \cong u_{mb}(t)$ bzw. $UM1a = UM1_{ao} + u_{m1a}(t)$ und $UM1b = UM1bo + u_{m1b}(t)$ mit vzw. $u_{m1a}(t) \cong U_{m1b}(t)$ sowie $UM2a = UM2ao + u_{m2a}(t)$ und $UM2b = UM2bo + um2b(t)$ moduliert, wobei ein Symmetrieabgleich der Ausleseströme $IA1$ und $IA2$ wahlweise im optischen Bereich erfolgen kann, und der OEP nach Maßgabe der Modulation vzw. zwischen den Modulationszuständen MZP mit positivem Auslesestrom und MZN mit negativem Auslesestrom betrieben.

Beim Zweifach-OEP z.B. mit Wired-OR-Stromauslese kann der Modulationsgrad des Auslesestroms der Signalwelle vzw. bei gleich verteilter Intensitätsverteilung auf den Teil-OEP1 und Teil-OEP2 vom Maximalwert 100% mit $IAS = IA1 + IA2$ und mit $IA1 = IA2$ durch eine gegenläufige Unsymmetrie der Tastverhältnisse von MZP1/MZN1 bzw. MZP2/MZN2 linear bis 0%, was dem modulationslosen Nullzustand MZP1/MZN2 oder MZN1/MZP2 und somit in der Summe dem Nullzustand MZ0 entspricht, verringert werden.

Bei der Differenzauslese der Ausleseeinheit werden für den Maximalwert beide Teil-OEPs gegenphasig bzw. komplementär mit MZN/MZP moduliert.

Zur Auswertung des gesuchten Mischproduktes weist die Verknüpfungs- und Ausleseeinheit VAEH vzw. Selektions- und Filtereigenschaften auf, z.B. im Frequenzband für eine bestimmte Mischfrequenz. Der Mischprozeß wird in zahlreichen Anwendungen wie im OE-Lock-in-Verstärker, OE-Phasenregelkreis (OE-PLL), in der Laufzeitmessung von Laserradars, verbunden mit einer Kurzzeitintegration und somit einer Korrelation, und als OE-Frequenzkonverter eingesetzt.

Für das Korrelationsergebnis wird das Mischprodukt im Basisband vzw durch eine Kurzzeitintegration ermittelt, vzw. durch einen Millerintegrator mit Reset Schaltern.

Ein besonderer Vorteil des OEP-Mischers und OEP-Korrelators besteht in der schnellen Umschaltmöglichkeit der Modulationssignale und Modulationszustände durch eine entsprechend schnelle Modulationsquelle MQ.

Vorteilhaft sind vor allem der mögliche Zeitmultiplexbetrieb und der Burst-Betrieb durch das schnelle vollständige An- und das Abschalten des Auslesestroms in den Nullzustand MZ0.

Der Einsatz des neuen OEP-Korrelators erfolgt vorteilhaft in der optischen Nachrichtenübertragung, z.B. in der diffusen Freiraumkommunikation in Hallen und Räumen aber auch in relativ kleinen Gerätegehäusen, in der allgemeinen und mikrosystemtechnischen Optischen Verbindungstechnik und den sog. Optical Backplanes als Multilayer-Verdrahtungsergänzung sowie in leitungsgebundenen optischen Netzen, z.B. Polymerfaser-LAN im Automotive-Bereich. Hierbei wird eine relativ hohe Bandbreite bzw. Bitrate am Ausgang mittels MSM-OEP ermöglicht.

Der relativ niederohmige Eingang der Ausleseschaltung und das geringe Übersprechen des Modulationssignals über die kleinen Sperrschichtkapazitäten z.B. der MSM-Strukturen erlauben kurze Integrationszeiten und damit hohe Bitraten. Durch Code-, Phasen- und Zeitmultiplexbetrieb (CDMA und TDMA) und weitere Multiplexverfahren in einem solchen Netz kann die Anzahl der Kanäle aufgrund der besonderen Eigenschaften des Correlated und des Non Correlated Balanced Sampling in den Empfangsknoten z.B. auf über 100 erhöht werden. Der Grund liegt in der fast vollständigen Unterdrückung solcher Signalwellen, die nicht mit dem Modulationssignal korrelieren.

In einer weiteren Ausgestaltung des erfindungsgemäßen Verfahrens wird für unbekannte Signalwellen der Korrelationsprozeß mit geeigneten Modulationssignalen des OEP dadurch erreicht, daß die Signalwelle erst durch eine geeignete Modulation unmittelbar vor Eintritt in die OEP-Empfangseinrichtung durch eine zusätzliche vzw. in das OEP-System integrierte Modulationsvorrichtung, deren Modulation mit der des OEP in einer bestimmten Beziehung steht, erfolgt.

Die Aufgabe besteht z.B. in der hochempfindlichen und preisgünstigen Erfassung von Wärmebildern. Herkömmliche Wärmebildkameras arbeiten etwa im 3 - 10μm-Wellenlängenbereich mit entsprechend geeigneten Halbleitermaterialien und z.B. einer Kühlung mit flüssigem Stickstoff zur Unterdrückung des starken Wärmerauschens des Detektors.

Die einfache Struktur des erfindungsgemäßen OEP-Pixels läßt sich außer in der schnellen MSM-Technologie je nach spektraler Zielsetzung durch viele Halbleiterwerkstoffe und -technologien realisieren, z.B. in Si-Bipolartechnologie (die vzw. metallischen Streifenstrukturen decken dabei z.B. $n^+$-Kathodenstreifen über $p^-$-Silizium ab. Für den fernen Infrarot- und für den Wärmestrahlungsbereich kann z.B. Indium-Antimonid InSb und HgCdTe eingesetzt werden. Da die Dunkelströme z.B. durch eine Rechteck-Modulation zwischen den Zuständen MZP und MZN weitgehend durch den Effekt des Correlated Balanced Sampling (CBS) unterdrückt werden, erreicht man auch ohne die übliche teure Kühlung hohe Empfindlichkeiten. Dazu wird bei der Bildaufnahme die einfallende Signalwelle im Takt der Modulation z.B. durch eine rotierende Chopperscheibe oder durch ein Array von Mikrospiegeln (Digital Mirror Devices) mit der gleichen Phase und Frequenz rechteckmoduliert. OEP-Empfängermaterialien für den Wärmestrahlungsbereich ermöglichen mit modulierbaren Wärmestrahlern, z.B. Quantenkaskadenlasern (QCL) ein OEP-Wärmestrahlungsradar.

In einer weiteren Ausgestaltung der Erfindung werden ein Verfahren zur Steigerung der Empfindlichkeit der OEP-Empfangseinrichtung und eine Vorrichtung zur Durchführung dieses Verfahrens angegeben.

Neben den bekannten und erläuterten Möglichkeiten zur Steigerung der Empfindlichkeit wie spektraler Filterung der Signalwelle, Correlated-Balanced-Sampling usw. kann der OEP-Empfangsfläche, die vzw. aus einer OEP-Zeile oder einer OEP-Matrix besteht, eine Bildverstärkereinheit zur Verstärkung der Intensität und/oder zur spektralen Umsetzung der Signalwelle vorgeschaltet werden.

Bei dem erfindungsgemäßen Verfahren wird die Signalwelle zunächst in ihrem räumlichen Querschnitt eines Photonenstroms durch vzw. eine Photokathode direkt oder mittelbar z.B. über eine Szintillatorschicht für den Röntgenbereich in einen entsprechenden Querschnitt eines Elektronenstroms umgewandelt.

Im Vakuum liegt die OEP-Oberflächenstruktur der Photokatodenfläche vzw. als parallele Fläche und zugleich auf positivem Annodenpotential direkt gegenüber. So erfahren die von der Signalwelle ausgelösten Photoelektronen auf der Vakuumseite der Photokatode eine Beschleunigung entsprechend dem mit $U_A$ definierten Potentialunterschied von z.B. 10 bis 1000 Volt, der in einfacher Weise steuerbar oder regelbar ist. Die Ionisierungswirkung und Bildung von Ladungsträgerpaaren im sensitiven Bereich 3 wird durch die erhöhte Energie der auftreffenden Elektronen von $eU_A$ nahezu um ein entsprechendes Maß verstärkt. Die Funktionsweise des OEP-Prinzips wird dabei von einer Signalwelle von vzw. Photonen auf beschleunigte Elektronen bzw. Betastrahlen ausgedehnt.

Die so erzielbare extrem hohe Empfindlichkeit bei gleichzeitig hoher Unterdrückung nicht korrelierter Signalwellen erlaubt vielfältige Messverfahren, z.B. eine verbesserte Infrarot- und Röntgen-Tomographie in der Medizintechnik, wobei die hohe Zeitauflösung des OEP-Arrays eine eigene oder kombinierte Laufzeit-Tomographie über schnelle Infrarotquellen- bzw. Röntgenquellen-Modulation ermöglicht.

In einer weiteren Ausgestaltung der Erfindung kann die OEP-Empfindlichkeit durch eine zwischen Photokatode und OEP-Empfangsfläche durchgeführte Elektronenvervielfachung weiter erhöht werden.

Dazu ist z.B. ein Array von Photovervielfachern, vzw. eine Mikrokanalplatte MCP (Micro Channel Plate) vzw. vom gleichen Flächenprofil der Photokathode und der OEP-Empfangsfläche vorgesehen, deren OEP-strukturierte Frontseiten-Metallisierung auf einem ersten Anodenpotential liegt. Ein zweites Anodenpotential gegenüber dem ersten auf der Rückseite der Mikrokanalplatte beschleunigt die Elektronen innerhalb der Mikrokanäle durch eine MCP-Spannung von z.B. 1000 Volt, wodurch eine Sekundärelektronenvervielfachung mit etwa 1000-facher Stromverstärkung erzielt wird. Die Oberflächenstruktur des OEP liegt auf einem dritten Anodenpotential von z.B. 10 - >1000V und kann so zu einer weiteren regelbaren Verstärkung durch die Photoelektronenenergie mit bis zu 1000-facher Stromverstärkung beitragen. Ein solcher OEP-Infrarot-Bildverstärker oder OEP- Röntgen-Bildverstärker erzielt auf kleinstem Raum extreme Verstärkungen mit dem Vorteil der Zeitselektion und Störstrahlungsunterdrückung. Als getastete OEP-3D-Bildverstärkerkamera sind auf diese Weise erfindungsgemäß Reichweiten im km-Bereich z.B. mit Anwendungsmöglichkeiten in der Luftdatenvermessung und in der Luft-, Raum-und Seefahrt erzielbar.

In einer weiteren Ausgestaltung der Erfindung kann eine Entfernungsmessung nach dem Laserradarprinzip mit einer lateralen Geschwindigkeitsmessung vorteilhaft in einer integrierenden Funktionsweise und zu einem integrierten Gerät vereint werden.

Dabei arbeitet ein OEP-Array zeitweilig im Modus eines pixelweise bzw. räumlich parallelen Korrelationsempfanges im Zeitbereich und zeitweilig im Modus eines zeitlich parallelen Korrelationsempfanges im Ortsbereich. Erstere eignet sich optimal für die Abstandsmessung und deren erste Ableitung, die orthogonale Geschwindigkeitsmessung $v_{rad}$ über die Echolaufzeit eine die Signalwelle rückstreuenden Oberfläche und letztere optimal für eine an sich bekannte laterale Geschwindigkeitsmessung $v_{lat}(v_x,v_y)$ dieser Oberfläche.

Die zeitliche Korrelation je OEP-Pixel realisiert für die einfallende Signalwelle eine Filterung und Messung im Zeit- und Frequenzbereich und bei bekannter Ausbreitungsgeschwindigkeit die Bildpunkt-Tiefe.

Die OEP-Matrix realisiert erfindungsgemäß eine laterale räumliche Korrelation z.B. für die einfallende Signalwelle eines zufälligen Bodenbildes mit einem Testmuster bzw. Gewichtungsmuster konstanter MZP- und MZN-Zustände bzw. eine Filterung und Messung im Ortsbereich und im Ortsfrequenzbereich in aufeinander folgenden Schritten. Dabei wird die Signalwelle des Bodenbildes P(x,y) bzw. ihre 2D-Fourier-Transformierte **P** $(f_x,f_y)$ zum Zeitpunkt ti mit der Gewichtung G(x,y) eines Testmusters, z.B. durch eine regelmäßige OEP-Matrix im Ortsbereich mit P(x,y)**G(-x,-y), korreliert bzw. im Ortsfrequenzbereich mit der 2D-Fourier-Transformierten gemäß **P** $(f_x,f_y)$ x **G\*** $(f_x,f_y)$ multipliziert.

Erfindungsgemäß werden beide Möglichkeiten mit dem gleichen OEP-Array durch Umschaltung der OEP-Funktionen und spezifischer Auswertung vorgeschlagen und können in einem "Motion-over-Ground"- OEP-Sensor vereinigt werden, wie z.B. für die Sicherheit im Straßenverkehr von großer Bedeutung.

Beispielhaft ausgehend von einer OEP-Matrix werden drei Betriebsarten realisiert, 1) die einer OEP-3D-Kamera mit räumlicher Tiefenmessung wie in zahlreichen Veröffentlichungen zur PMD-3D-Kamera beschrieben und mit der 3D-OEP-Kamera vorteilhaft realisierbar, 2) die einer geregelten, situationsbedingten Nullschaltung für einen von der Leistungsbilanz her optimierten Burst-Betrieb und 3) die vektorielle Laterale Geschwindigkeitsmessung.

Zur dritten Betriebsart wird zunächst z.B. von einem OEP-Streifenmuster quer zur Fahrtrichtung x oder einem Streifenmuster senkrecht dazu oder von einem OEP-Schachbrettmuster als Testmuster ausgegangen, bei denen z.B. alle hellen Streifen bzw. Felder im MZP-Zustand einen zugehörigen positiven Photostrom liefern, während die dunklen Felder im MZN-Zustand einen negativen Photostrom liefern. Die Ausleseströme werden bzgl. der zu messenden Geschwindigkeitsrichtung im Gegentakt zusammengefaßt, beim OEP-Schachbrettmuster geteilt für zwei Richtungen. Es filtert entsprechend seiner Abbildung auf einer Oberfläche als zweidimensionales Ortsfilter bzw. Ortsfrequenzfilter mit der abgebildeten OEP-Kantenlänge Dx und Dy als halber Musterperiode und den entsprechenden Ortsfrequenzen $f_{Dx}$ = 1/2Dx und $f_{Dy}$ = 1/2Dy das erfaßte Bodenbild bezüglich der $f_{Dx}$-und $f_{Dy}$-Spektralkomponenten. Ohne Lateralbewegung wird die Amplitude Ax bzw. Ay der Leistungsdichten bei diesen Ortsfrequenzen gemessen.

Bei einer Bewegung der 3D-OEP-Kamera im lateralen Betriebszuständen z.B. über einen beleuchteten Boden wechselt die Phase bzw. Amplitude im Hell-Dunkel-Wechsel mit der Dauer $T_t$ = 2D/v bzw. mit der Zeitfrequenz $f_t$ = 1/$T_t$. Damit ergeben sich die gesuchten Geschwindigkeiten als vektorielle Komponenten einer Längs- und Querkomponente der Geschwindigkeit eines Fahrzeugs

$$v_x = 2Dx/T_{tx} = f_{tx}/f_{Dx} \text{ und } v_y = 2Dy/T_{ty} = f_{ty}/f_{Dy}.$$

Da die abgebildete Kantenlänge D des OEP-Pixels über den optischen Maßstabsfaktor der 3D-Kamera vom Abstand abhängt, ist zusätzlich intermittierend oder zumindest mit Teilen der OEP-Matrix eine Abstandsmessung durchzuführen, die erfindungsgemäß im Zeitmultiplex sequentiell oder im Raummultiplex parallel erfolgen kann.

In einer weiteren Ausgestaltung der Erfindung wird vorgeschlagen, erfindungsgemäße OEP-Doppelfunktion-Sensoren dieser Art bei Fahrzeugen vorzugsweise in peripheren Fahrzeugteilen, insbesondere in den Außenspiegeln und beim LKW in Stoßstangen - auch zur automatischen geschwindigkeitsabhängigen Dämpfungsregelung - einzusetzen. Bei der Integration dieses "Motion-over-Ground"-OEP-Sensors übernimmt dieser vzw. als 3D-Boden-Kamera zugleich die Überwachung der betreffenden Fahrzeugseite.

Die relativ große Spiegelfläche und das Volumen des Außenspiegels wird für mindestens eine weitere rückwärts schauende 3D-Kamera für die Überwachung des Verkehrs im sog. Blinden Winkel und für eine vorwärts messende 3D-Kamera vorgeschlagen. Senden und Empfangen der Signalwellen der "Blind Spot"-3D-OEP-Kamera erfolgt vzw. im Infrarotbereich und zweckmäßig durch die im sichtbaren Bereich transparente Spiegelfläche.

In einer weiteren Ausgestaltung der Erfindung wird ein OEP-Meßverfahren vorgeschlagen, das sich vorteilhaft zur Vermessung von speziellen Laufzeiten, insbesondere von Relaxationszeiten, bei der Analyse chemischer und biologischer Substanzen eignet. Das prinzipielle Verfahren zur OEP-Stoffanalyse und die Vorrichtung zur Durchführung des Verfahrens kann mit der Anwendung der OEP-3D-Kamera verglichen werden. Die zu analysierenden Stoffe, Substanzen, Materialien usw. werden vom Sender moduliert bestrahlt, vzw. sinusförmig und mit mindestens einer Kreisfrequenz $\omega$, die für die zu untersuchenden Relaxationszeiten bestimmter Quantenübergänge geeignet ist und in mindestens einem Spektralbereich $\lambda$, der zur Anregung dieser Energieübergänge geeignet ist. Das z.B. mit $\lambda_{UV}$ im Ultraviolettbereich angeregte Material antwortet bei mit der entsprechenden sinusförmigen Rückstreuung oder Transmission bei $\omega$, die 1) je nach dessen Fluoreszenzeigenschaften um die Phase $\phi=\omega\tau$ bzw. Laufzeit $\tau$ verzögert sein kann in einem weiten Bereich von Femtosekunden bis hin zu Millisekunden und die 2) in anderen, i. Allg. niedrigeren Spektralbereichen des Signalwellenträgers rückstreut bzw. die im Bereich der bestimmter Quantenübergänge spektrale Absorptionsbereiche oder -linien in der Transmission aufweist.

Eine Dimension des OEP-Arrays dient vzw. der Abbildung der spektralen Zerlegung der rückgestreuten oder transmittierten Signalwellen über $\lambda$ und die andere Dimension dient der parallelen Vermessung vieler Materialproben, z.B. längs einer Probenzeile.

Die gesuchte Kombination von Spektrallinie und Relaxationszeit $\tau = \phi/\omega$ ermöglicht mit dem OEP-Array große Fortschritte in der schnellen und präzisen Stoffanalyse, insbesondere in der zeitaufgelösten Spektralanalyse.

Weitere Vorteile, Merkmale und Anwendungsmöglichkeiten der vorliegenden Erfindung ergeben sich aus der Beschreibung bevorzugter Ausführungsformen anhand der Figuren:

Fig. 1    ein einfaches OEP-Element, bestehend aus einer zusammengeschalteten Gruppe von Ausleseelektroden und jeweils zwei zusammengeschalteten Gruppen von Modulationselektroden,

Fig. 2    eine schematische Darstellung des Zweifach-OEPs analog zum Einfach-OEP in Fig. 1, jedoch mit einer Schaltungsausführung einer nachgeschalteten Ausleseeinheit,

Fig. 3    eine schematische Darstellung der Struktur des Vierfach-OEPs in 4-Quadrantenform,

Fig. 4    ein Blockschaltbild eines OEP-Sensoriksystems bzw. eines einfachen Kommunikationssystems,

Fig. 5    das Blockschaltbild eines komplexen OEP-Kommunikationssystems insbesondere für die Freiraumkommunikation,

Fig. 6    das Blockschaltbild eines Routers bzw. einer optischen Vermittlungseinheit auf OEP-Basis,

Fig.7    eine OEP-Schnittstellenkomponente und

Fig. 8    eine OEP-Ausführung für extrem hohe Empfindlichkeit mit Bildverstärkung.

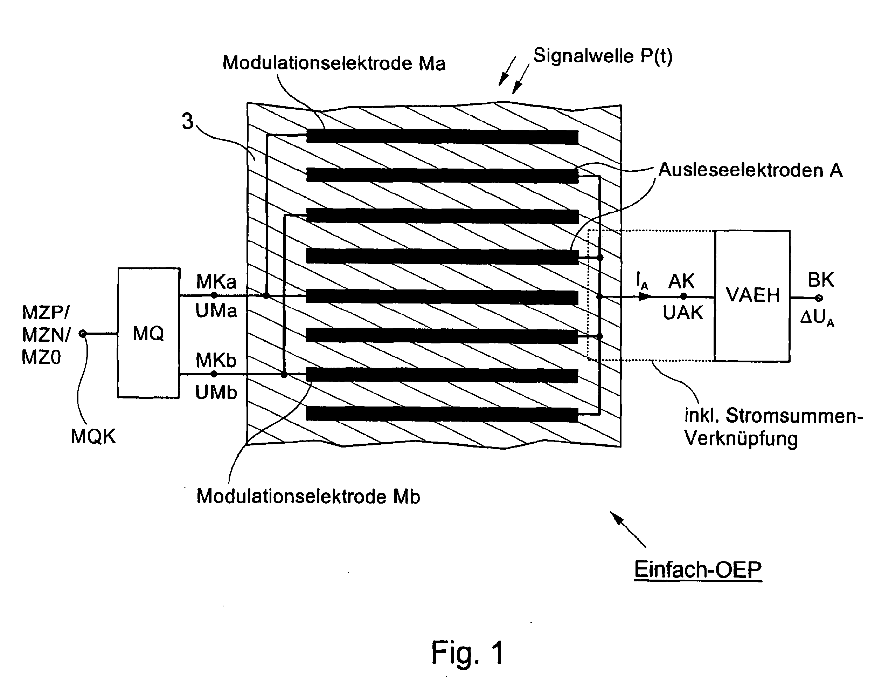

**Fig.1** zeigt die Oberfläche eines für Signalwellen sensitiven Gegenstands 3 mit einer regelmäßigen Belegung von gleichartigen Modulationselektroden Ma und Mb, zwischen denen jeweils die Ausleseelektroden A liegen. Eine möglichst gleich verteilte Signalwelle P(t) generiert in dem so gekennzeichneten Modulations- und Auslesebereich zwischen den Elektroden Ladungsträger. Die Modulationselektroden werden von der Modulationsquelle MQ an den Klemmen MKa und MKb mit den zugehörigen Modulationsspannungen UMa und UMb moduliert und beeinflussen so die Verteilung und Richtung des ausgelesenen Ladungsträgerstroms IA an der Ausleseklemme AK. Das Auslesepotential UAK wird vzw. zu Null bzw. auf Massepotential mittels einer niederohmigen Ausleseeinheit VAEH gewählt. Markante Modulationszustände, die über die Eingangsklemme MQK der Modulationsquell MQ vorgegeben werden können, sind erstens der mit MZP bezeichnete Zustand mit maximal positivem Stromzustand IAmax, zweitens MZN mit maximal negativem Stromzustand IAmin und drittens der Kompensations- oder Nullzustand MZ0 mit IA = 0.

Bei diesem dargestellten Einfach-OEP wird eine Nullschaltung im Modulationszustand MZO mit IA = 0 dadurch erreicht, daß Unsymmetrien der Modulationsspannungen einen Stromausgleich zwischen den kurzschlußmäßig verbundenen Ausleseelektroden stattfindet. Hier ist aus zeichnerischen Gründen die maximale Verschachtelung der beiden Gruppen von Modulationselektroden gewählt, die in der Praxis bei z.B. 50 bis 100 Streifenelektroden nicht erforderlich ist.

Weiterhin wird in Fig. 1 durch die strichlierte Ausdehnung der Verknüpfung und Ausleseeinheit VAEH verdeutlicht, daß beim Einfach-OEP durch Stromsummen-Verknüpfung bereits vor der weiteren Signalverarbeitung eine OEP-inhärente Verknüpfung der verschieden beeinflußbaren Ausleseströme auf dem OEP-Element stattfindet.

Wie in **Fig. 2** dargestellt können die prinzipiell gleichen Eigenschaften auch mit einer Aufteilung der OEP-Struktur in zwei Teil-OEPs, mit dem sog. Zweifach-OEP erzielt werden. Dabei wird zunächst von einer einzigen Signalwelle P(t) mit gleich verteilter Leistung ausgegangen. Die Summe der Ströme kann durch eine Wired-OR-Schaltung WOR an der entsprechenden Ausleseklemme AKS zusammengefaßt werden. Durch gleichsinnige oder gegensinnige Modulation der Ströme der beiden Teil-OEPs 1 und 2 können diese in der Summe von Imax über Null bis Imin gesteuert werden.

Die beiden Ströme IA1 und IA2 können auch getrennt von einer Verknüpfungs- und Ausleseeinheit VAEH - wie in Fig. 2 alternativ zur Wired-OR-Auslese WOR dargestellt - von einem Differenz-Millerintegrator mit den beiden Operationsverstärkern V ausgelesen werden. Das entspricht der Wirkung einer Subtraktion der Ströme, und man erhält den Nullzustand MZ0 mit der Kombination MZP1/MZP2 oder MZN1/MZN2.

Die dabei unvermeidlich entstehenden Gleichtaktanteile laden die Auslesekapazitäten $C_{A1}$ und $C_{A2}$ und nach der Verzögerungszeit der Operationsverstärker V die Millerkapazitäten Cf1 und Cf2 gleichsinnig auf, ohne daß dadurch eine Gegentaktausgangsspannung $\Delta U_A$, die für die Auswertung z.B. der Korrelationsfunktion oder logischen Verknüpfung von optischen und elektrischen Signalen interessiert, verfälscht wird.

Dauerzustände dieser Art können jedoch zur Gleichtaktübersteuerung der Schaltung führen. Sie werden je nach Betriebsweise der OEP-Schaltung zyklisch durch die Reset-Schalter RS der Miilerkapazitäten Cf1 und Cf2 vermieden. Sicher und hinreichend vermieden wird die Gleichtaktübersteuerung durch die angegebene erfindungsgemäße Schaltung über die $R_{ev}$-$R_{ev}$-Brückenschaltung, die nur den ausgangsseitigen Gleichtaktanteil $U_{ev}$ abgreift und ihn verstärkt über R1 und R2 gegengekoppelt und als kompensierenden Strom an den beiden Verstärkereingängen AK1 und AK2 einspeist. In dieser Gegenkopplungsschaltung kann die Verstärkung der Steuergröße $U_{ev}$ und kompensierende symmetrische Stromeinspeisung an den Klemmen AK1 und AK2 vorteilhaft 1) über eine Schaltung GKV2, eine gesteuerte Spannungsquelle VUev, an den Ausgangsklemmen G1 und G2 oder 2) über die Schaltung GKV3, eine gesteuerte Stromquelle $SU_{ev}$, erfolgen.

3) Eine hochsymmetrische Gegenkopplung und Stromaufteilung kann über einen FET-Differenzverstärker als Gate-Basisverstärker GBV erfolgen, der auf kleinstem Raum zweckmäßig unter Einsparung von R1 und R2 mikroelektronisch integriert wird - vorteilhaft mit einer über gleiche Gate-Spannungen UGa und UGb, über den Innenwiderstand Rev/2 der Gleichtaktspannungsquelle $U_{ev}$ und über die FET-Steilheiten einstellbare Stromverstärkung.

An den beiden Klemmen K1 und K2 kann das kapazitive Übersprechen der Modulationssignale auf die Ausleseelektroden durch entsprechende Gegentaktsignale an $C_{K1}$ und $C_{K2}$ kompensiert werden.

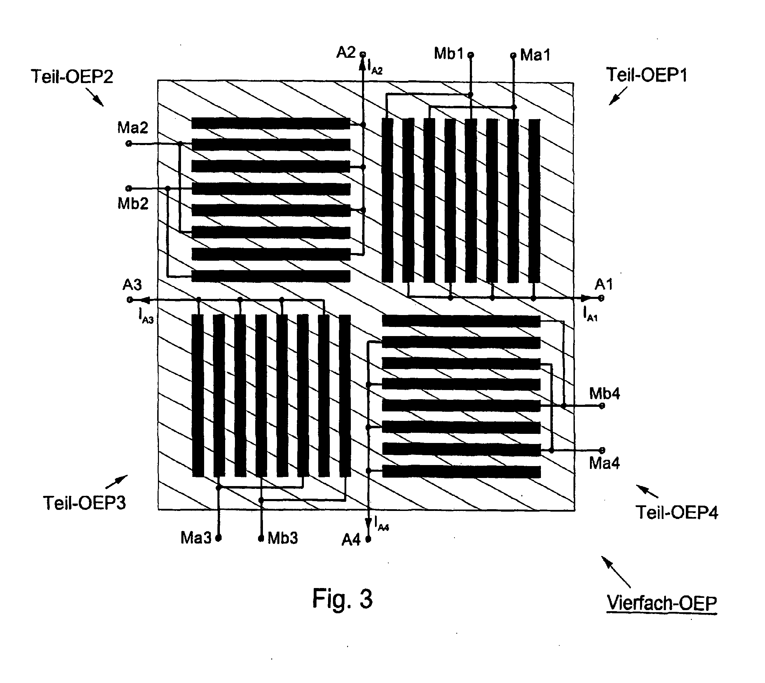

**Fig. 3** stellt schematisch in der Aufsicht ein Vierfach-OEP dar, das sowohl die Funktion des Einfach-OEP als auch des Zweifach-OEP zu ersetzen vermag und flexibel für eine 4-, 2- und 1-fach Messung dient. Darüber hinaus wird die Bestimmung der Phase einer Korrelationsfunktion durch die mögliche Parallelmessung - z.B. IQ-Messung bei Sinussignalen - in einem Vorgang bestimmt. Die orthogonale Ausrichtung der benachbarten Fingerstrukturen führt vorteilhaft zu minimalem Übersprechen.

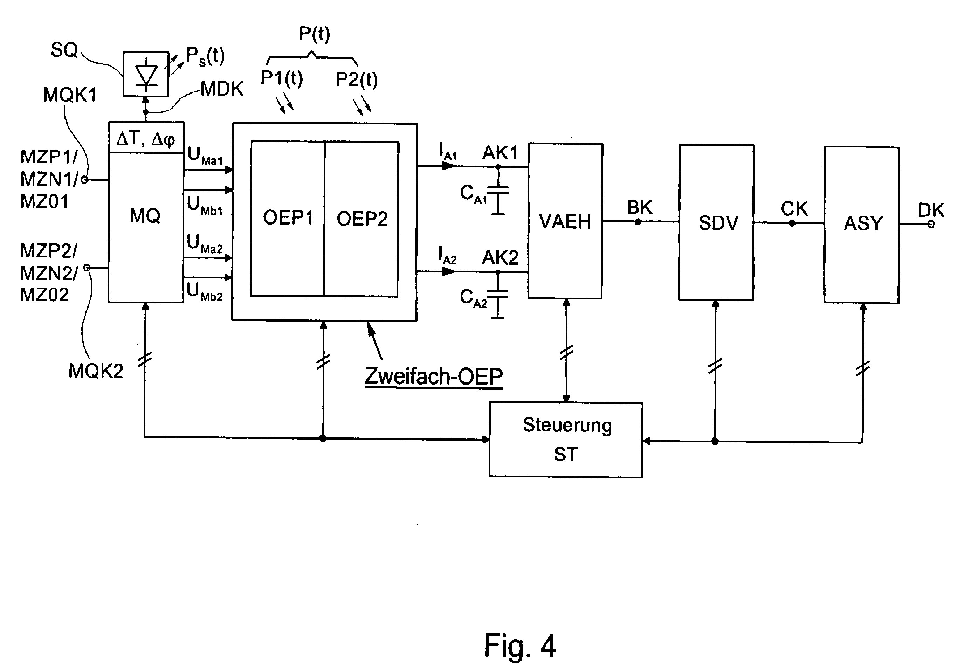

**Fig. 4** veranschaulicht in einem Blockschaltbild den Aufbau eines OEP-Sensorik-Systems am Beispiel eines Zweifach-OEPs, der hier stellvertretend für eine OEP-Zeile oder OEP-Matrix steht.

Eine optische Signalquelle SQ wird über die Modulationsquelle MQ mit wählbarer Verzögerung $\Delta T$ bzw. $\Delta \varphi$ moduliert und sendet die Signalwelle $P_s(t)$ aus. Sie regt z.B. in der Fluoreszenz-Spektroskopie eine Probe an oder beleuchtet beim Laserradar eine 3D-Szene. Die empfangene Signalwelle P(t) = P1(t) + P2(t) wird durch geeignete Modulationsspannungen, die in Beziehung zur Signalquellenmodulation stehen, demoduliert. Es folgen die Verarbeitungs-/ Verknüpfungs- und Auswerteeinheiten VAEH, Signal- und Datenverarbeitungssystem SDV und Aktoriksystem ASY. Die Steuerung ST sorgt für die Abstimmung und Optimierung der Meßverläufe.

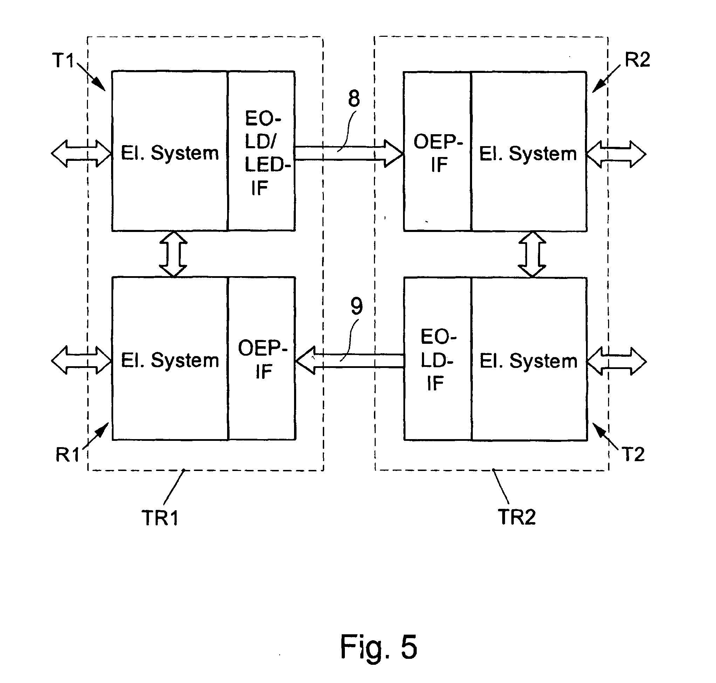

**Fig. 5** stellt schematisch das Blockschaltbild für den Informationsaustausch von zwei Systemen bzw. Netzteilnehmern über OEP-Arrays und LED/Laserdioden-Arrays dar, insbesondere für neue Anwendungen in der Freiraumkommunikation z.B. in der Raumfahrt, innerhalb von Räumen, Fahrzeugen, Geräten und in optisch transparenten Leiterplatten, aber auch in bidirektional genutzten lokalen Polymerfasernetzen. Ein Transmitter/Receiver-System TR1 sendet über das elektro-optische Interface der LEDs oder Laserdioden über den Strahlungsweg 8 über vorwiegend diffuse Streuung codierte Daten an ein OEP-Interface mit einer Mehrzahl von OEP-Empfängern und einem nachgeschalteten Elektroniksystem (EL-System). Der Rückkanal verläuft je nach Anwendung direkt über den Transmitter T2 oder über ein lokales oder Weitverkehrsnetz.

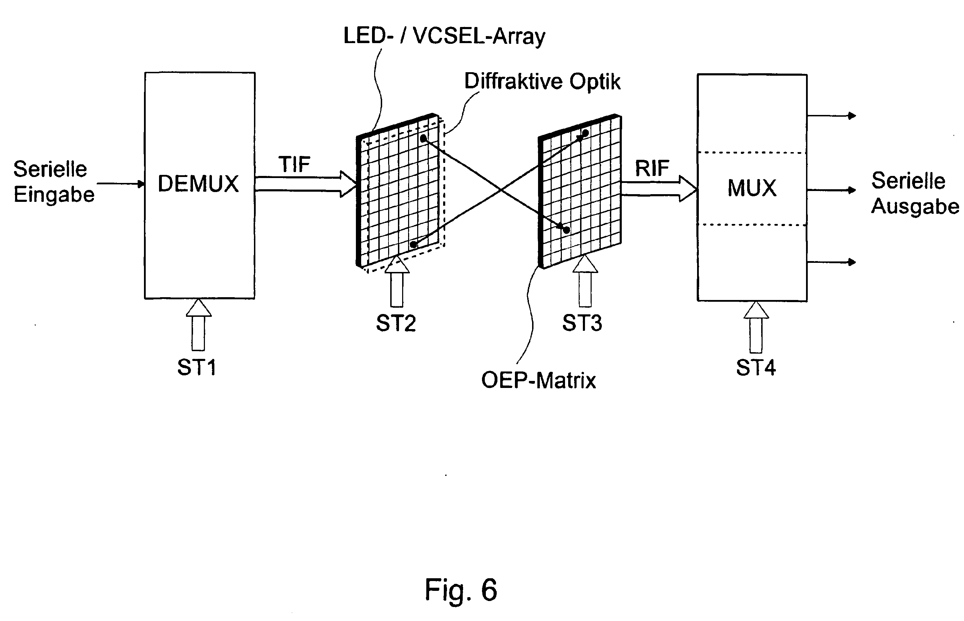

In **Fig. 6** wird vereinfacht ein über die Eingänge ST1-4 gesteuerter Router bzw. eine optische Vermittlungseinheit (Optical Cross Connect) im Blockschaltbild dargestellt. Der serielle Eingangsdatenstrom wird über einen eingangsseitigen Demultiplexer DEMUX und über ein paralleles Transmitter-Interface ITF auf ein LED- bzw. Laserdioden- bzw. VCSEL-Array und weiter über eine diffraktive Optik für eine gleichmäßige Leistungsverteilung auf eine OEP-Matrix gegeben. Die Zuordnung der zu vermittelnden Kanäle geschieht im Code- und Zeitmultiplex. Die parallelen Ausgänge der OEP-Matrix führen über das parallele Receiver-Interface RIF auf einen ausgangsseitigen Multiplexer MUX zur vorwiegend seriellen Ausgabe der gerouteten bzw. vermittelten Datenströme.

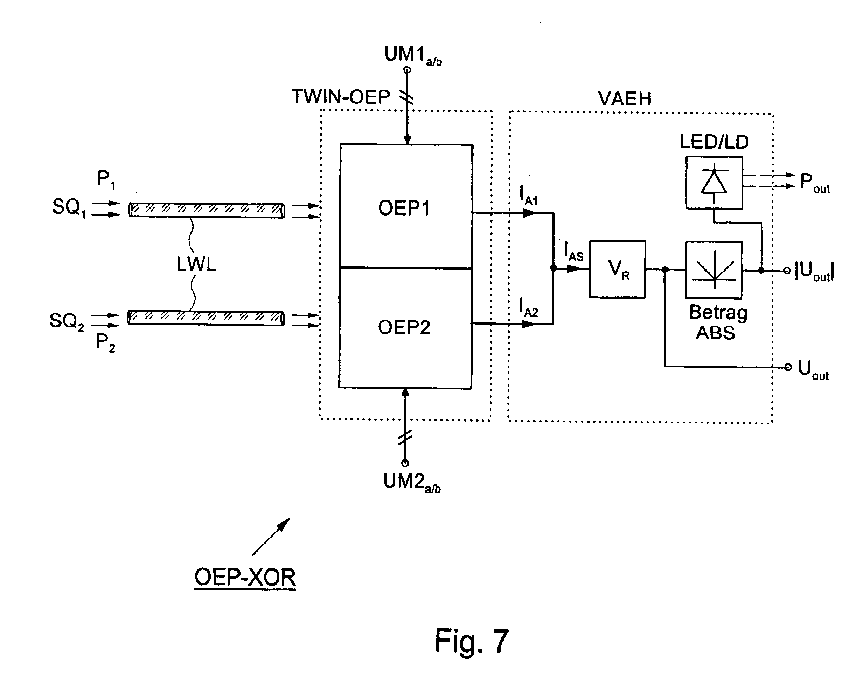

**Fig. 7** zeigt schematisch einen neuartigen OEP-Logikbaustein, der beispielhaft demonstrieren soll, wie ein optisch-elektronisches Interface sowohl die Geschwindigkeit wesentlich zu steigern als auch den Aufbau wesentlich zu vereinfachen vermag.

Zwei Signalquellen SQ1 und SQ2 koppeln die Signalwellen P1 und P2 über Lichtwellenleiter LWL auf das Zweifach-OEP (Twin-OEP) mit OEP1 und OEP2.

Die Ausgangsströme IA1 und IA2 werden durch UM1a/b und UM2a/b gesteuert und zu $I_{AS}$ zusammengeführt. Auf den Strom/Spannungsverstärker $V_R$ mit positiver Verstärkung und dem Ausgang $U_{out}$ folgen ein Betragsglied ABS mit $|U_{out}|$ und eine LED/Laserdiode mit $P_{out}$.

Diese einfache OEP-Musterschaltung erfüllt vier Funktionen:

1. P1 und P2 sind bzgl. $|U_{out}|$ und $P_{out}$ für die Modulationszustände MZ1P/MZ1 N logisch über XOR verknüpft
2. Für MZ1 P/MZ2P sind P1 und P2 über OR verknüpft.
3. Mit P1 und P2 "High" kann ein logischer Zustand UM2a/b als $P_{out}$ sehr schnell rein optisch ausgelesen werden.
4. Mit P1 "High" und dem Modulationszustand UM1P/UM2N kann der P2-Zustand rein optisch unmittelbar an $U_{out}$ weitergegeben und z.B. in einen Speicher eingeschrieben werden.

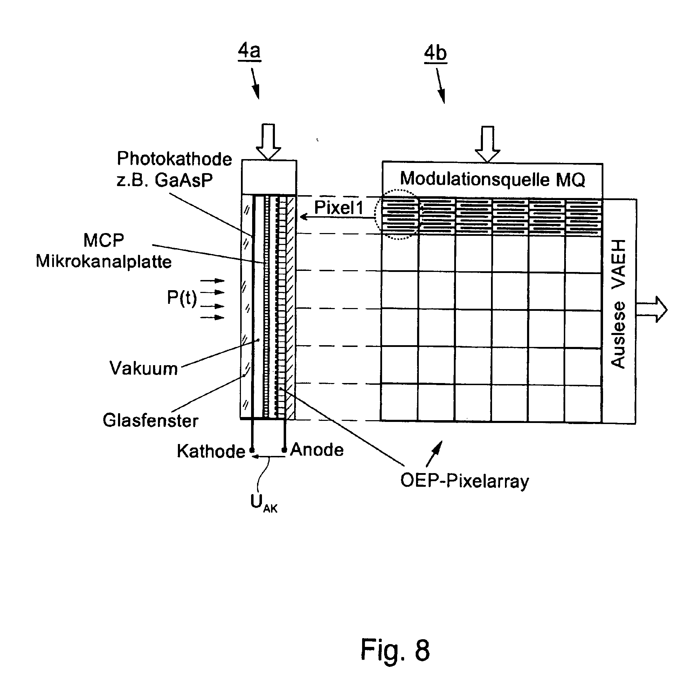

**Fig. 8** skizziert eine Möglichkeit zur Empfindlichkeitssteigerung des OEP-Prinzips.

In einer ersten Ausführung ohne die eingezeichnete Mikro-Kanalplatte MCP besteht der OEP-Bildverstärker aus der linksseitigen Photokathode, auf die die Signalwelle P(t) trifft. Auf der Vakuumseite der Photokathode entsteht ein Abbild des Photoneneinfalls als Elektronenaustritt. Durch eine hinreichend positive Spannung der OEP-Empfangsfläche, die als positive Anode gegenüber der Kathode wirkt, treffen die Elektronen mit entsprechend hoher Energie eUA auf den Photosensitiven Bereich 3. Dieser Energiezuwachs hat eine entsprechende Erhöhung der Paarbildung und damit eine Steigerung der Empfindlichkeit zur Folge.

Durch das Einfügen einer Mikrokanalplatte MCP wie dargestellt, kann bei entsprechenden Betriebsspannungen die Empfindlichkeit weiter erhöht werden.

Der rechte Teil in Fig. 8 zeigt schematisch eine Aufsicht auf die Pixelstruktur.

## Patentansprüche

1. Verfahren zur Erfassung und/oder Verarbeitung von Signalwellen, die in einem auf die Signalwellen empfindlichen Gegenstand Ladungsträger erzeugen, die in mindestens einer Ausleseelektrode einen Signalstrom hervorrufen, wobei mindestens zwei Modulationselektroden vorgesehen sind, von denen mindestens eine in räumlicher Nähe zu der mindestens einen Ausleseelektrode, und die andere Modulationselektrode in räumlicher Nähe entweder zu derselben Ausleseelektrode oder zu einer weiteren Ausleseelektrode derart angeordnet sind, daß in Abhängigkeit vom Vorzeichen der Modulationsspannung der jeweiligen Modulationselektrode der über die zugehörige Ausleseelektrode fließende Strom positiv oder negativ ist, **dadurch gekennzeichnet, daß** die Modulationselektroden mit relativ zueinander frei wählbarer Spannungsamplitude und/oder Phasenbeziehung moduliert werden, wobei die durch die Modulationsspannungen beider Modulationselektroden erzeugten Ausleseströme additiv gekoppelt werden.

2. Verfahren nach Anspruch 1, **dadurch gekennzeichnet, daß** die räumliche Anordnung der Modulationselektroden zu den Ausleseelektroden und/oder die Spannungsamplituden der Modulationsspannungen derart gewählt werden, daß bei entgegengesetztem Vorzeichen der Modulationsspannungen die addierten Ausleseströme sich gegenseitig aufheben.

3. Verfahren nach Anspruch 1 oder 2, **dadurch gekennzeichnet, daß** eine der Modulationsspannungen eine konstante Spannung ist, während die andere ein frei wählbar wechselndes Vorzeichen hat.

4. Verfahren nach einem der Ansprüche 1 bis 3, **dadurch gekennzeichnet, daß** die Amplituden der Modulationsspannungen variierbar sind.

5. Verfahren nach einem der Ansprüche 1 bis 4, **dadurch gekennzeichnet, daß** mehrere verschiedene Signalströme, die durch unterschiedliche Signalwellen auf getrennten Elementen erzeugt werden, miteinander kombiniert, insbesondere addiert werden.

6. Verfahren nach einem der Ansprüche 1 bis 5, wobei auch die Signalwellen moduliert werden und die Modulationen der Modulationselektroden in wohldefinierter Beziehung zu der Modulation der Signalwellen stehen.

7. Verfahren nach Anspruchs 6, **dadurch gekennzeichnet, daß** die Ausleseelektroden und Modulationselektroden als Photo-Misch-Detektor-Elemente, PMD-Elemente, verwendet werden, indem beide Modulationselektroden phasengleich einen schnellen Vorzeichenwechsel der Modulationsspannung erfahren und der Auslesestrom über mindestens eine solche Periode integriert wird.

8. Verfahren nach Anspruch 6, wobei die Ausleseelektroden und Modulationselektroden durch Änderung der Phasen- und/oder Amplitudenbeziehungen der Modulationssignale im Wechsel oder parallel als PMD-Elemente und/oder als Optoelektronische-Prozessor-Elemente, OEP-Elemente, betrieben werden, wobei vorzugsweise die OEP-Elemente in einem Array, die wahlweise durch räumlich wechselnde Modulationszustände MZP und MZN betreibbar sind, eine Musteranalyse oder eine Ortsfrequenzanalyse von Signalwellen durchführen.

9. Verfahren nach einem der Ansprüche 1 bis 8, **dadurch gekennzeichnet, daß** die Verknüpfung von Auslesesignalen verschiedener Ausleseelektroden insbesondere die Addition, Subtraktion bzw. Addition mit variabel einstellbarer Phasenbeziehung sowie logische Verknüpfungen AND, OR, XOR und deren Verneinungen umfaßt.

10. Verfahren nach einem der Ansprüche 1 bis 9, **dadurch gekennzeichnet, daß** der OptoElektronische Prozessor OEP, der vorzugsweise eine niedrige Substratdotierung aufweist, mittels Steuerung durch drei abgestimmte Modulationsspannungsspannungszustände drei zugehörige Auslesestromzustände liefert, einen ersten Modulationszustand MZP (UMaP, UMbP) mit positivem, vzw. maximalem Auslesestrom IAP, einen zweiten Modulationszustand MZN (UMaN, UMbN) mit negativem, vzw. minimalem Austesestrom IAN und einen dritten Modulationszustand MZO (UMaP, UMbN) bzw. MZO(UMaN, UMbP) mit verschwindendem Auslesestrom IA0=0.

11. Verfahren nach einem der Ansprüche 1-10, **dadurch gekennzeichnet, daß** eine Integration des Auslesestroms IAS erfolgt und bei dem eine Nullschaltung des integrierten Auslesestroms bzw. der Ausleseladung QS **dadurch** erfolgt, daß vzw. nach vorangehender Nullschaltung der Ladung QS eine hochfrequente symmetrische Umschaltung der beiden Modulationszustände MZP und MZN erfolgt.

12. Verfahren nach einem der Ansprüche 1-11, **dadurch gekennzeichnet, daß** die OEP-Streifenstrukturen Avalanche-Halbleiterstrukturen aufweisen, Ionisierungseffekte schneller Elektronen nutzen oder mit Elektronenvervielfachern verbunden sind, bei dem insbesondere die durch die Signalwelle erzeugten Ladungsträger bzw. die Auslesestöme durch Vervielfachung verstärkt werden, zum einen durch den Avalanche-Effekt durch geeignet vorgespannte pn- bzw. Schottky-Übergänge im Halbleitersubstrat, wobei die Modulationsspannungen vzw. in der Amplitude geregelt werden, weiterhin durch Vorschalten einer Photokathode und durch Sekundärelektronenvervielfachung der Photoelektronen im Vakuum mittels Mikrokanalplatten oder Photovervielfachem, wobei entweder das Elektronenabbild zunächst in ein optisches Bild zurück gewandelt wird oder direkt durch die OEP-Struktur ausgelesen wird, wobei im letzteren Fall die Sekundär-Photoeffekte der hochenergetischen Elektronen im OEP-Substrat eine erhebliche Ladungsträgervervielfachung genutzt wird.

13. Verfahren nach einem der Ansprüche 1-11, **dadurch gekennzeichnet, daß** die Photoelektronen der Photokathode ohne Einsatz einer Mikrokanalplatte unmittelbar auf die OEP-Oberfläche hin abbildend beschleunigt werden und durch Ionisierung und Ladungsträgergeneration eine hohe, über die Beschleunigungsspannung einfach regelbare Verstärkung ermöglichen.

14. Vorrichtung zur Erfassung und Verarbeitung von Signalwellen, mit einem auf die Signalwellen empfindlichen Gegenstand OEP, in welchem die Signalwellen Ladungsträger erzeugen, und mit mindestens einer mit dem Ladungsträgerbereich des Gegenstandes verbundenen Ausleseelektrode (AK), wobei mindestens zwei Modulationselektroden (MKa, MKb) vorgesehen sind, von denen mindestens eine in räumlicher Nähe zu der mindestens einen Ausleseelektrode (AK) und die andere in räumlicher Nähe entweder zu derselben Ausleseelektrode (AK) oder zu einer weiteren Ausleseelektrode (AK2) angeordnet ist, **dadurch gekennzeichnet, daß** die Modulationselektroden relativ zu der bzw. den Ausleseelektroden derart angeordnet sind, daß in Abhängigkeit vom Vorzeichen der Modulationsspannungen der jeweiligen Modulationselektroden der über die zugehörige Ausleseelektrode fließende Strom positiv oder negativ ist und daß mindestens eine Einrichtung vorgesehen ist, durch welche die relative Phasenbeziehung und/oder die Spannungsamplitude der beiden Modulationsspannungen frei einstellbar ist.

15. Vorrichtung nach Anspruch 14, **dadurch gekennzeichnet, daß** der auf die signalwellen empfindliche Gegenstand ein lichtempfindliches Halbleitermaterial ist.

16. Vorrichtung nach Anspruch 14, **dadurch gekennzeichnet, daß** der auf die signalwellen empfindliche Gegenstand eine Photokathode ist, ausgestattet mit für den Betrieb im Vakuum geeigneten Modulationselektroden zur Modulation der Photoelektronen in Bezug auf geeignet ausgeführte Ausleseelektroden in mindestens einer Einfach-OEP- oder Zweifach-OEP-Struktur, wobei die Ausleseelektroden vorzugsweise mit einer vorgeschalteten Sekundärelektronenvervielfachung, vorzugsweise als Mikrokanalplatten-Elemente ausgeführt sind und wobei der Auslesestrom mit einer Anodenauslesestruktur oder mit einer entsprechend angepaßten CCD-oder CMOS- oder MSM-Kamerachip-Struktur ausgelesen wird.

17. Vorrichtung nach einem der Ansprüche 14 oder 15, **dadurch gekennzeichnet, daß** die Auslese- und Modulationselektroden Metall-Halbleiter-Kontakte bzw. Schottky-Dioden sind.

18. Vorrichtung nach einem der Ansprüche 14 bis 17, **dadurch gekennzeichnet, daß** die Ausleseelektroden (AK, AK1, AK2) und mindestens jeweils eine Modulationselektrode (MKa) kammartig ineinandergreifen, wobei die Ausleseelektrode mit einer weiteren, gleichermaßen ausgebildeten Ausleseelektrode verbunden ist, die mit der zweiten Modulationselektrode (MKb) kammartig ineinandergreift.

19. Vorrichtung nach einem der Ansprüche 14 bis 18, **dadurch gekennzeichnet, daß** eine Mehrzahl voneinander unabhängiger Ausleseelektroden und zugehöriger Modulationselektroden in einem Array angeordnet sind.

20. Vorrichtung nach einem der Ansprüche 14 bis 19, **dadurch gekennzeichnet, daß** Einrichtungen zur Modulation der Signalwelle bzw. Signalwellen vorgesehen sind.

21. Vorrichtung nach einem der Ansprüche 14 bis 20, **dadurch gekennzeichnet, daß** eine OEP-Struktur als PLL- oder DLL-Schaltung ausgeführt ist, und zwar vorzugsweise als Array, z.B. in einem Router, und/oder daß eine PLL- oder DLL-Eingangsschaltung zur Erfassung der Signalmodulation bzw. Codierung und zur Anpassung der Modulationsfrequenz sowie der Phasen der Modulation der Modulationselektroden an die Signalwellenmodulation vorgesehen ist.

22. Vorrichtung nach einem der Ansprüche 14 bis 21, **dadurch gekennzeichnet, daß** die streifenförmigen Modulations- und Ausleseelektroden des Optoelektronischen Prozessors OEP durch Metallelektroden als Schottky-Kontakte vzw. der Breite von 0,1 - 5$\mu$m auf sensitivem, der Signalwelle angepaßten Halbleitersubstrat 3, vzw. einem hochohmigen (p$^-$)- oder (n$^-$)-Substrat oder einer hochohmigen (p$^-$)- oder (n$^-$)-Epitaxieschicht vzw. mit Zwischenräumen etwa der gleichen bis mehrfachen Breite und vzw. einer an die Eindringtiefe der Signalwelle angepaßten Dicke realisiert werden, wobei das Substrat 3 vzw. auf freiem Potential (Floating Substrate) liegt.

23. Vorrichtung nach einem der Ansprüche 14 bis 22, **dadurch gekennzeichnet, daß**, die streifenförmigen Modulationselektroden M und Ausleseelektroden A durch (n$^+$)- bzw. (p$^+$)-Streifen bzw. -Kanäle z.B. der Breite im ca. 0,1 - 5$\mu$m-Bereich auf sensitivem, der Signalwelle angepaßten Halbleitersubstrat 3 bzw. der Epitaxieschicht 3, vzw. ein eigenleitendes bis hochohmiges (p$^-$)- bzw. (n$^-$)-Substrat, das vzw mit den Streifenelektroden sperrende PN-Übergänge mit tief ausgedehnter Raumladungszone bildet und vzw. mit Zwischenräumen etwa der gleichen bis mehrfachen Breite realisiert werden.

24. Vorrichtung nach einem der Ansprüche 14 bis 23, **dadurch gekennzeichnet, daß** jeweils die Elektroden M und/oder A durch vzw. isolierte Abschirm-Metallelektroden geeigneter Breite bedeckt sind und vzw. kapazitiv mit Modulationsquellen verbunden sind, wobei die M-Abschirm-Metallelektroden und die A-Abschirm-Metallelektroden vorzugsweise mit Gegentakt-Modulationsquellen verbunden sind.

25. Vorrichtung nach einem der Ansprüche 14 bis 24, **dadurch gekennzeichnet, daß** die Ausleseeinheit VAEH des Einfach-OEP mit der inhärent enthaltenen Verknüpfung der Ausleseströme Einflußbereiche der mindestens zwei Modulationsspannungen bzw. die Verknüpfungs- und Ausleseeinheit VAEH des Mehrfach-OEP eingangsseitig als niederohmige Stromausleseschaltung ausgeführt ist.

**26.** Vorrichtung nach einem der Ansprüche 14 bis 25, **dadurch gekennzeichnet, daß** die Stromausleseschaltung der Teil-OEPs einzeln oder gruppenweise als direkte Stromsummierung entsprechend dem Wired-OR-Prinzip, vzw. mit nachfolgend einfachem Millerintegrator für Korrelationsanwendungen, ausgeführt ist oder bei dem z.B. zwei Teil-OEPs durch einen Differenz-Millerintegrator ausgelesen werden, wobei die Polarität der Modulationsspannungen für diese Modulationszustände MZP (positiv/negativ), MZN (negativ/positiv) und MZ0 (beide positiv oder beide negativ) gegenüber der Wired-OR-Summation berücksichtigt wird.

**27.** Vorrichtung nach einem der Ansprüche 14 bis 26, **dadurch gekennzeichnet, daß** die OEP-Struktur bzw. die OEP-Funktionalität in Metallelektroden (ME)-pn-Technologie oder in Schottky-Technologie mit einem dem Wellenlängenbereich der Signalwelle angepaßten Halbleitersubstrat 3, z.B. in Si, vzw. in CMOS-Technologie, GeSi-Quantum-Well-Strukturen, GaAs, InGaAsP, InSb, HgCdTe usw. als vzw. hochohmiges n-Substrat oder p-Substrat ausgeführt ist.

**28.** Vorrichtung nach einem der Ansprüche 14 bis 27, **dadurch gekennzeichnet, daß** das kapazitive Übersprechen eines hochfrequenten Modulationssignals von den Modulationselektroden auf die Ausleseelektroden und auf die Ausleseklemme AK durch eine entsprechende kapazitive Kompensation mit einer entsprechenden Gegentaktspannung unterdrückt wird.

**29.** Vorrichtung nach einem der Ansprüche 14 bis 28, **dadurch gekennzeichnet, daß** die Zweifach- oder Vierfach-OEPs auf eine OEP-Matrix der Größe M x N erweitert sind, wobei M und N ganze Zahlen größer als 1 sind.

**30.** Vorrichtung nach einem der Ansprüche 14 bis 29, **dadurch gekennzeichnet, daß** eine Ausleseelektrodengruppe z.B. an der Ausleseklemme AK eine Kapazität CA gegen Masse aufweist und vzw. an einen Transimpedanzverstärker angeschlossen ist, mit einer ohmschen Transimpedanz für Logik- und Mischanwendungen und einer kapazitiven Transimpedanz als Millerintegrator für Korrelationsanwendungen, wobei die letztere Schaltung mindestens einen Resetschalter aufweist, und wobei vzw. die gleiche Klemme AK über eine geeignete Kapazität CK zur Kompensation des Übersprechens der Modulationselektroden auf die Ausleseelektroden an eine zur jeweiligen Modulationsspannung komplementäre Spannung angeschlossen ist.

**31.** Vorrichtung nach einem der Ansprüche 14 bis 30, **dadurch gekennzeichnet, daß** die OEP-Strukturen auf der Seite der einfallenden Signalwelle mit antireflektiven Beschichtungen und vzw. unter Berücksichtigung der Teil-OEPs mit Mikrolinsen versehen sind und vzw. mit reflektiven Schichten auf der gegenüberliegenden Seite versehen sind und daß die Signalquelle SQ und die OEP-Empfangseinrichtung jeweils mit einer geeigneten Optik versehen sind.

**Claims**

**1.** A method of detecting and/or processing signal waves which in an article sensitive to the signal waves produce charge carriers which induce a signal current in at least one readout electrode, wherein there are provided at least two modulation electrodes, at least one of which is arranged in spatial proximity with the at least one readout electrode and the other modulation electrode is arranged in spatial proximity either with the same readout electrode or a further readout electrode in such a way that in dependence on the sign of the modulation voltage of the respective modulation electrode the current flowing by way of the associated readout electrode is positive or negative, **characterised in that** the modulation electrodes are modulated with a voltage amplitude and/or phase relationship which can be freely selected relative to each other, wherein the readout currents produced by the modulation voltages of both modulation electrodes are additively coupled.

**2.** A method according to claim 1 **characterised in that** the spatial arrangement of the modulation electrodes relative to the readout electrodes and/or the voltage amplitudes of the modulation voltages are so selected that with opposite signs of the modulation voltages the added readout currents mutually cancel each other out.

**3.** A method according to claim 1 or claim 2 **characterised in that** one of the modulation voltages is a constant voltage while the other is of a freely selectably alternating sign.

**4.** A method according to one of claims 1 to 3 **characterised in that** the amplitudes of the modulation voltages are variable.

**5.** A method according to one of claims 1 to 4 **characterised in that** a plurality of different signal currents which are produced by different signal waves on separate elements are combined together, in particular added.

6. A method according to one of claims 1 to 5 wherein the signal waves are also modulated and modulations of the modulation electrodes are in well-defined relationship with the modulation of the signal waves.

7. A method according to claim 6 **characterised in that** the readout electrodes and the modulation electrodes are used as photomixing detector (PMD) elements insofar as both modulation electrodes experience in in-phase relationship a fast change in sign of the modulation voltage and the readout current is integrated over at least one such period.

8. A method according to claim 6 wherein the readout electrodes and modulation electrodes are operated by changing the phase and/or amplitude relationships of the modulation signals alternately or parallel as PMD elements and/or optoelectronic processor (OEP) elements, wherein preferably the OEP elements in an array which are operable selectively by spatially alternating modulation conditions MZP and MZN implement pattern analysis or position frequency analysis of signal waves.

9. A method according to one of claims 1 to 8 **characterised in that** the interlinking of readout signals of various readout electrodes includes in particular addition, subtraction or addition with variably adjustable phase relationship and logical interlinkings AND, OR, XOR and the negations thereof.

10. A method according to one of claims 1 to 9 **characterised in that** the optoelectronic processor OEP which preferably has a low level of substrate doping, by means of control by three matched modulation voltage conditions, provides three associated readout current conditions, a first modulation condition MZP (UMaP, UMbP) with a positive, preferably maximum readout current IAP, a second modulation condition MZN (UMaN, UMbN) with a negative, preferably minimum readout current IAN and a third modulation condition MZ0 (UMaP, UMbN) or MZ0 (UMaN, UMbP) respectively with a vanishing readout current IA0 = 0.

11. A method according to one of claims 1 to 10 **characterised in that** integration of the readout current IAS is effected and in which zero switching of the integrated readout current or the readout charge QS is effected **in that**, preferably after preceding zero switching of the charge QS, high-frequency symmetrical switching-over of the two modulation conditions MZP and MZN occurs.

12. A method according to one of claims 1 to 11 **characterised in that** the OEP strip structures have avalanche semiconductor structures, use ionisation effects of fast electrons or are connected to electron multipliers, in which in particular the charge carriers produced by the signal wave or the readout currents are amplified by multiplication, on the one hand by the avalanche effect by suitably biased pn- or Schottky junctions in the semiconductor substrate, wherein the modulation voltages are preferably regulated in respect of amplitude, further by upstream connection of a photocathode and by secondary electron multiplication of the photoelectrons in vacuum by means of micro-channel plates or photomultipliers, wherein either the electron image is firstly converted back into an optical image or is read out directly by the OEP structure, wherein in the latter case the secondary photoeffects of the high-energy electrons in the OEP substrate involves a considerable charge carrier multiplication.

13. A method according to one of claims 1 to 11 **characterised in that** the photoelectrons of the photocathode are image-formingly accelerated without using a micro-channel plate directly onto the OEP surface and by virtue of ionisation and charge carrier generation permit a high level of amplification which can be easily regulated by way of the acceleration voltage.

14. Apparatus for detecting and processing signal waves, with an article OEP which is sensitive to the signal waves and in which the signal waves produce charge carriers, and at least one readout electrode (AK) connected to the charge carrier region of the article, wherein there are provided at least two modulation electrodes (MKa, MKb) of which at least one is arranged in spatial proximity with the at least one readout electrode (AK) and the other is arranged in spatial proximity either with the same readout electrode (AK) or a further readout electrode (AK2), **characterised in that** the modulation electrodes are arranged relative to the readout electrode or electrodes in such a way that in dependence on the sign of the modulation voltages of the respective modulation electrodes the current flowing by way of the associated readout electrode is positive or negative and that there is provided at least one device by which the relative phase relationship and/or the voltage amplitude of the two modulation voltages can be freely set.

15. Apparatus according to claim 14 **characterised in that** the article sensitive to the signal waves is a photosensitive semiconductor material.

16. Apparatus according to claim 14 **characterised in that** the article sensitive to the signal waves is a photocathode, provided with modulation electrodes suitable for operation in vacuum for modulation of the photoelectrons in relation to suitably designed readout electrodes in at least one single OEP or twin OEP structure, wherein the readout electrodes are preferably provided with an upstream-connected secondary electron multiplication means, preferably in the form of micro-channel plate elements, and wherein the readout current is read out with an anode readout structure or with a suitably adapted CCD or CMOS or MSM camera chip structure.

17. Apparatus according to one of claims 14 and 15 **characterised in that** the readout and modulation electrodes are metal semiconductor contacts or Schottky diodes.

18. Apparatus according to one of claims 14 to 17 **characterised in that** the readout electrodes (AK, AK1, AK2) and at least one respective modulation electrode (MKa) interengage comb-like, wherein the readout electrode is connected to a further readout electrode designed in the same manner, which interengages comb-like with the second modulation electrode (MKb).

19. Apparatus according to one of claims 14 to 18 **characterised in that** a plurality of mutually independent readout electrodes and associated modulation electrodes are arranged in an array.

20. Apparatus according to one of claims 14 to 19 **characterised in that** there are provided devices for modulation of the signal wave or waves.

21. Apparatus according to one of claims 14 to 20 **characterised in that** an OEP structure is in the form of a PLL or DLL circuit, more specifically preferably in the form of an array, for example in a router, and/or that there is provided a PLL or DLL input circuit for detecting signal modulation or encoding and for adapting the modulation frequency and the phases of modulation of the modulation electrodes to the signal wave modulation.

22. Apparatus according to one of claims 14 to 21 **characterised in that** the strip-shaped modulation and readout electrodes of the optoelectronic processor OEP are embodied by metal electrodes as Schottky contacts, preferably of a width of 0.1 - 5 $\mu$m, on a sensitive semiconductor substrate 3 adapted to the signal wave, preferably a high-ohmic (p-)- or (n-)-substrate or a high-ohmic (p-)- or (n-)-epitaxial layer, preferably with intermediate spaces of approximately the same to multiple width and preferably of a thickness adapted to the depth of penetration of the signal wave, wherein the substrate 3 is preferably at free potential (floating substrate).

23. Apparatus according to one of claims 14 to 22 **characterised in that** the strip-shaped modulation electrodes M and readout electrodes A are embodied by (n+)- and (p+)-strips or channels, for example of a width in the approximately 0.1 to 5 $\mu$m range, on a sensitive semiconductor substrate adapted to the signal wave or the epitaxial layer 3, preferably an intrinsically conducting to high-ohmic (p-)- or (n-)-substrate respectively which preferably with the strip electrodes forms blocking PN junctions with a deeply extended space charge zone and preferably with intermediate spaces approximately of the same to multiple width.

24. Apparatus according to one of claims 14 to 23 **characterised in that** in each case the electrodes M and/or A are covered by preferably insulated screening metal electrodes of suitable width and are preferably capacitively coupled to modulation sources, wherein the M-screening metal electrodes and the A-screening metal electrodes are preferably connected to push-pull modulation sources.

25. Apparatus according to one of claims 14 to 24 **characterised in that** the readout unit VAEH of the single OEP with the inherently contained interlinking of the readout currents involves influence regions of the at least two modulation voltages or the interlinking and readout unit VAEH of the multiple OEP is in the form at the input side of a low-ohmic current readout circuit.

26. Apparatus according to one of claims 14 to 25 **characterised in that** the current readout circuit of the partial OEPs is individually or group-wise in the form of direct current summing corresponding to the wired-OR principle, preferably with subsequently single Miller integrator for correlation applications or in which for example two partial OEPs are read out by a differential Miller integrator, wherein the polarity of the modulation voltages is taken into consideration for those modulation conditions MZP (positive/negative), MZN (negative/positive) and MZ0 (both positive or both negative) with respect to the wired-OR summing.

27. Apparatus according to one of claims 14 to 26 **characterised in that** the OEP structure or the OEP functionality is effected in metal electrodes (ME)-pn technology or in Schottky technology with a semiconductor substrate 3 adapted to the wavelength range of the signal wave, for example of Si, preferably CMOS technology, GeSi quantum well structures, GaAs, InGaAsP, InSb, HgCdTe etc. as a preferably high-ohmic n-substrate or p-substrate.

28. Apparatus according to one of claims 14 to 27 **characterised in that** capacitive crosstalk of a high-frequency modulation signal from the modulation electrodes to the readout electrodes and to the readout terminal AK is suppressed by suitable capacitive compensation with a suitable push-pull voltage.

29. Apparatus according to one of claims 14 to 28 **characterised in that** the twin or quadruple OEPs are enlarged to an OEP matrix of the size M x N, wherein M and N are integers greater than 1.

30. Apparatus according to one of claims 14 to 29 **characterised in that** a readout electrode group for example at the readout terminal AK has a capacitance CA in relation to earth and is connected preferably to a transimpedance amplifier, with an ohmic transimpedance for logic and mixing applications and a capacitive transimpedance as a Miller integrator for correlation applications, wherein the latter circuit has at least one reset switch, and wherein preferably the same terminal AK is connected by way of a suitable capacitor CK for compensation of the crosstalk of the modulation electrodes to the readout electrodes to a voltage which is complementary in relation to the respective modulation voltage.

31. Apparatus according to one of claims 14 to 30 **characterised in that** the OEP structures on the side of the incident signal wave are provided with anti-reflective coatings and preferably having regard to the partial OEPs with microlenses and are preferably provided with reflective layers on the opposite side, and that the signal source SQ and the OEP receiving device are each provided with a suitable optical means.

**Revendications**

1. Procédé de détection et/ou de traitement d'ondes de signaux qui, dans un objet sensible aux ondes de signaux, génèrent des porteurs de charge, entraînant un courant de signaux dans au moins une électrode de lecture, dans lequel au moins deux électrodes de modulation sont prévues, dont au moins une est agencée à proximité d'au moins une électrode de lecture, et l'autre électrode de modulation est agencée à proximité soit de la même électrode de lecture soit d'une autre électrode de lecture, de telle sorte que, en fonction du signe de la tension de modulation de l'électrode de modulation respective, le courant circulant dans l'électrode de lecture associée est positif ou négatif, **caractérisé en ce que** les électrodes de modulation sont modulées avec une amplitude de tension et/ou un rapport de phases pouvant être choisis librement l'un par rapport à l'autre, les courants de lecture étant couplés par addition par les tensions de modulation des deux électrodes de modulation.

2. Procédé selon la revendication 1, **caractérisé en ce que** l'agencement spatial des électrodes de modulation par rapport aux électrodes de lecture et/ou les amplitudes de tension des tensions de modulation sont choisis de telle sorte que, en cas de signe opposé des tensions de modulation, les courants de lecture cumulés s'annulent mutuellement.

3. Procédé selon la revendication 1 ou 2, **caractérisé en ce qu'**une des tensions de modulation est une tension constante, tandis que l'autre présente un signe alternant pouvant être choisi librement.

4. Procédé selon l'une des revendications 1 à 3, **caractérisé en ce que** les amplitudes des tensions de modulation sont variables.

5. Procédé selon l'une des revendications 1 à 4, **caractérisé en ce que** plusieurs courants de signaux différents, générés par différentes ondes de signaux différentes sur des éléments séparés, sont combinés les uns avec les autres, en particulier cumulés.

6. Procédé selon l'une des revendications 1 à 5, dans lequel les ondes de signaux sont également modulées et les modulations des électrodes de modulation ont un rapport univalent avec la modulation des ondes de signaux.

**7.** Procédé selon la revendication 6, **caractérisé en ce que** les électrodes de lecture et les électrodes de modulation sont utilisées en tant qu'éléments de détecteur photonique mixte, éléments PMD, les deux électrodes de modulation subissant en phase un changement de signe rapide de la tension de modulation et le courant de lecture étant intégré au moins sur une telle période.

**8.** Procédé selon la revendication 6, **caractérisé en ce que** les électrodes de lecture et les électrodes de modulation sont utilisées en tant qu'éléments PMD et/ou en tant qu'éléments de processeur optoélectronique, éléments OEP, en alternance ou en parallèle, suite à un changement des rapports de phases et/ou d'amplitudes des signaux de modulation, de préférence les éléments OEP dans une matrice, qui peuvent être exploités au choix par des états de modulations MZP et MZN alternant dans l'espace, effectuant une analyse d'échantillon ou une analyse de fréquence de lieu des ondes de signaux.

**9.** Procédé selon l'une des revendications 1 à 8, **caractérisé en ce que** la combinaison de signaux de lecture de différentes électrodes de lecture comprend l'addition, la soustraction respectivement l'addition avec un rapport de phases réglable de manière variable, ainsi que des combinaisons logiques ET, OU, OU exclusif et leurs négations.

**10.** Procédé selon l'une des revendications 1 à 9, **caractérisé en ce que** le processeur optoélectronique OEP, qui présente de préférence un dopage de substrat faible, fournit au moyen de la commande par trois états de tension de modulation accordés, trois états de courants de lecture associés, un premier état de modulation MZP (UMaP, UMbP) avec un courant de lecture IAP positif de préférence maximal, un deuxième état de modulation MZN (UMaN, UMbN) avec un courant de lecture IAN négatif, de préférence minimal et un troisième état de modulation MZ0 (UMaP, UMbN) respectivement MZ0 (UMaN, UmbP) avec un courant de lecture IA0=0 infiniment petit.

**11.** Procédé selon l'une des revendications 1 à 10, **caractérisé en ce qu'**une intégration du courant de lecture IAS a lieu et dans lequel un montage zéro du courant de lecture intégré ou de la charge de lecture QS a lieu de telle sorte que, de préférence après le montage zéro mentionné de la charge de lecture QS, une commutation symétrique haute fréquence des deux états de modulation MZP et MZN se produit.

**12.** Procédé selon l'une des revendications 1 à 11, **caractérisé en ce que** les structures de bande OEP présentent des structures de semi-conducteurs à avalanche, utilisent des effets d'ionisation d'électrons plus rapides ou sont reliées à des multiplicateurs d'électrons, les porteurs de charge, en particulier, générés par l'onde de signal ou les courants de lecture étant amplifiés par la multiplication, d'une part par l'effet d'avalanche dû à des jonctions pn ou Schottky polarisées de manière appropriée dans le substrat semi-conducteur, dans lequel les tensions de modulation sont réglées de préférence en amplitude, et également par le montage en amont d'une photocathode et par la multiplication d'électrons secondaire des photoélectrons dans le vide au moyen de plaques à microcanaux ou de photomultiplications, dans lequel soit la représentation des électrons est tout d'abord transformée en une image optique, soit elle est directement lue par la structure OEP, dans ce dernier cas l'effet photoélectrique secondaire des électrons hautement énergétiques dans le substrat OEB nécessite une multiplication considérable des porteurs de charge.

**13.** Procédé selon l'une des revendications 1 à 11, **caractérisé en ce que** les photoélectrons de la photocathode sont accélérés de manière représentative, sans utiliser de plaque à microcanaux, directement sur la surface OEP et permettent, grâce à l'ionisation et à la génération de porteurs de charge une amplification importante, réglable de manière simple par l'intermédiaire de la tension d'accélération.

**14.** Dispositif de détection et de traitement d'ondes de signaux, comprenant un objet OEP sensible aux ondes de signaux, dans lequel les ondes de signaux produisent des porteurs de charge, et comprenant au moins une électrode de lecture (AK) reliée à la plage porteuse de charge de l'objet, dans lequel au moins deux électrodes de modulation (MKa, MKb) sont prévues, dont au moins une est agencée à proximité de l'électrode de lecture (AK) et l'autre électrode de modulation est agencée à proximité soit de la même électrode de lecture (AK), soit d'une autre électrode de lecture (AK2), **caractérisé en ce que** les électrodes de modulation sont disposées par rapport à l'électrode ou aux électrodes de lecture de telle sorte que, en fonction du signe des tensions de modulation des électrodes de modulation respectives, le courant circulant dans l'électrode de lecture associée est positif ou négatif, et au moins un dispositif permettant de régler librement le rapport de phases relatif et/ou l'amplitude de tension des deux tensions de modulation est prévu.

**15.** Dispositif selon la revendication 14, **caractérisé en ce que** l'objet sensible aux ondes de signaux est un matériau semi-conducteur sensible à la lumière.

**16.** Dispositif selon la revendication 14, **caractérisé en ce que** l'objet sensible aux ondes de signaux est une photocathode, munie d'électrodes de modulation appropriées pour l'utilisation dans le vide, destinées à la modulation des photoélectrons en rapport avec des électrodes de lecture mises en oeuvre de manière appropriée dans au moins une structure OEP simple ou OEP double, dans lequel les électrodes de lecture sont mises en oeuvre de préférence au moyen d'une multiplication d'électrons secondaire en amont, de préférence en tant qu'éléments de plaques à microcanaux, et dans lequel le courant de lecture est lu au moyen d'une structure de lecture à anode ou d'une structure de puce optique CCD, CMOS ou MSM adaptée correspondante.

**17.** Dispositif selon l'une des revendications 14 ou 15, **caractérisé en ce que** les électrodes de lecture et de modulation sont des contacts semiconducteur-métal respectivement des diodes Schottky.

**18.** Dispositif selon l'une des revendications 14 à 17, **caractérisé en ce que** les électrodes de lecture (AK, AK1, AK2) et au moins une électrode de modulation respective (MKa) s'engagent les unes dans les autres à la manière d'un peigne, l'électrode de lecture étant reliée à une autre électrode de lecture configurée de la même manière, qui s'engage à la manière d'un peigne avec la deuxième électrode de modulation (MKb).

**19.** Dispositif selon l'une des revendications 14 à 18, **caractérisé en ce qu'**une pluralité d'électrodes de lecture indépendantes les unes des autres et d'électrodes de modulation associées sont agencées sous la forme d'une matrice.

**20.** Dispositif selon l'une des revendications 14 à 19, **caractérisé en ce que** des systèmes sont prévus pour la modulation de l'onde de signal ou des ondes de signaux.

**21.** Dispositif selon l'une des revendications 14 à 20, **caractérisé en ce qu'**une structure OEP est mise en oeuvre en tant que circuit PLL ou DLL, et de préférence en tant que matrice, par exemple dans un routeur, et/ou **en ce qu'**un circuit d'entrée PLL ou DLL est prévu pour détecter la modulation des signaux ou le codage et pour adapter la fréquence de modulation ainsi que les phases de modulation des électrodes de modulation à la modulation des ondes de signaux.

**22.** Dispositif selon l'une des revendications 14 à 21, **caractérisé en ce que** les électrodes de modulation et de lecture en forme de bande du processeur optoélectronique OEP sont mises en oeuvre au moyen d'électrodes métalliques en tant que contacts Schottky, de préférence d'une largeur de 0,1 à 5 $\mu$m sur un substrat semi-conducteur 3 sensible, adapté à l'onde de signal, de préférence un substrat de valeur ohmique élevée (p⁻) ou (n⁻) ou une couche épitaxiale de valeur ohmique élevée (p⁻) ou (n⁻), de préférence avec des intervalles allant d'une largeur sensiblement identique à une largeur multiple et de préférence une épaisseur adaptée à la profondeur de pénétration de l'onde de signal, le substrat 3 reposant de préférence sur un potentiel libre (Substrat flottant).

**23.** Dispositif selon l'une des revendications 14 à 22, **caractérisé en ce que** les électrodes de modulation M en forme de bande et les électrodes de lecture A sont réalisées au moyen de bandes ou canaux (n⁺) ou (p⁺), par exemple d'une largeur comprise dans la plage allant de 0,1 à 5 $\mu$m, sur un substrat semi-conducteur 3 sensible, adapté à l'onde de signal ou la couche épitaxiale 3, de préférence un substrat (p⁻) ou (n⁻) intrinsèque à fortement résistant, qui forme de préférence avec les électrodes en bande des jonctions PN non conductrices avec une zone de charge spatiale profondément étendue et de préférence avec des intervalles allant d'une largeur sensiblement identique à une largeur multiple.

**24.** Dispositif selon l'une des revendications 14 à 23, **caractérisé en ce que** les électrodes M et/ou A respectivement sont recouvertes par des électrodes métalliques de protection de préférence isolées d'une largeur appropriée, et sont reliées de manière capacitive à des sources de modulation, les électrodes métalliques de protection M et les électrodes métalliques de protection A étant reliées de préférence à des sources de modulation symétriques.

**25.** Dispositif selon l'une des revendications 14 à 24, **caractérisé en ce que** l'unité de lecture VAEH de l'OEP simple est mise en oeuvre avec la combinaison contenue de manière inhérente des zones d'influence des courants de lecture d'au moins deux tensions de modulation, respectivement l'unité de combinaison et de lecture VAEH de l'OEP multiple est mise en oeuvre côté entrée en tant que circuit de lecture à courant de faible résistance.

**26.** Dispositif selon l'une des revendications 14 à 25, **caractérisé en ce que** le circuit de lecture à courant des OEP partiels est mis en oeuvre de manière individuelle ou en groupe en tant qu'addition directe des courants conformément au principe OU câblé, de préférence au moyen d'un simple intégrateur de Miller placé en aval pour les applications de corrélation, ou dans lequel par exemple deux OEP partiels sont lus par un intégrateur de Miller différentiel, la polarité des tensions de modulation pour ces états de modulation MZP (positif/négatif), MZN (positif/négatif) et MZ0 (les deux positifs ou les deux négatifs) étant considérée par rapport à la somme OU câblé.

**27.** Dispositif selon l'une des revendications 14 à 26, **caractérisé en ce que** la structure OEP respectivement la fonctionnalité OEP est mise en oeuvre, dans la technologie pn des électrodes métalliques (ME) ou dans la technologie Schottky, au moyen d'un substrat semi-conducteur 3 adapté à la plage de longueurs d'ondes de l'onde de signal, par exemple dans la technologie Si, de préférence CMOS, des structures à puits quantiques GeSi, GaAs, InGaAsP, InSb, HgCdTe et ainsi de suite, de préférence en tant que substrat n ou substrat p à forte résistance.

**28.** Dispositif selon l'une des revendications 14 à 27, **caractérisé en ce que** l'intermodulation capacitive d'un signal de modulation haute fréquence des électrodes de modulation sur les électrodes de lecture et sur la borne de lecture AK est atténuée par une compensation capacitive correspondante au moyen d'une tension symétrique correspondante.

**29.** Dispositif selon l'une des revendications 14 à 28, **caractérisé en ce que** les OEP doubles ou multiples sont étendus sur une matrice OEP de dimensions M x N, M et N étant des nombres supérieurs à 1.

**30.** Dispositif selon l'une des revendications 14 à 29, **caractérisé en ce qu'**un groupe d'électrodes de lecture présente, par exemple sur la borne de lecture AK, une capacité CA par rapport à la masse, et est raccordé de préférence à un amplificateur à impédance transversale, avec une impédance transversale ohmique pour des applications de logique et mixtes et une impédance transversale capacitive, en tant qu'intégrateur de Miller pour des applications de corrélation, le dernier circuit présentant au moins un bouton de réinitialisation, et de préférence la même borne AK étant raccordée, au moyen d'une capacité CK appropriée pour la compensation de l'intermodulation des électrodes de modulation sur les électrodes de lecture, à une tension complémentaire à la tension de modulation respective.

**31.** Dispositif selon l'une des revendications 14 à 30, **caractérisé en ce que** les structures OEP sont munies du côté de l'onde de signal incidente de revêtements anti-réfléchissants et de préférence de microlentilles en tenant compte des OEP partiels, et sont munies de préférence de couches réfléchissantes sur le côté opposé, et **en ce que** la source de signal SQ et le dispositif de réception OEP sont munis respectivement d'une optique appropriée.

Fig. 1

EP 1 481 472 B1

Fig. 2

Zweifach-OEP

EP 1 481 472 B1

Fig. 3

Teil-OEP2

Teil-OEP1

Teil-OEP3

Teil-OEP4

Vierfach-OEP

A2 $I_{A2}$   Mb1   Ma1

Ma2

Mb2

A3
$I_{A3}$

A1
$I_{A1}$

Mb4

Ma4

Ma3   Mb3   A4 $I_{A4}$

EP 1 481 472 B1

26

Fig. 4

EP 1 481 472 B1

Fig. 5

Fig. 6

EP 1 481 472 B1

Fig. 7

OEP-XOR

4a    4b

Photokathode
z.B. GaAsP

Modulationsquelle MQ

Pixel1

MCP
Mikrokanalplatte

P(t)

Auslese VAEH

Vakuum

Glasfenster

Kathode    Anode

OEP-Pixelarray

$U_{AK}$

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 19635932 A
- WO 9810255 A
- DE 19821974
- WO 9960629 A

- DE 0003632 W
- DE 0103914 W
- DE 19635932

**In der Beschreibung aufgeführte Nicht-Patentliteratur**

- Handbook of Computer Vision and Applications. Sensors and Imaging. Academic Press, vol. 1, 463ff

- **R. SCHWARTE.** *EDMO Proceedings,* 15-17